(19) Europäisches Patentamt
European Patent Office
Office européen des brevets

(11) EP 4 422 371 A1

(12) **EUROPEAN PATENT APPLICATION**

(43) Date of publication:
**28.08.2024 Bulletin 2024/35**

(21) Application number: **24158061.2**

(22) Date of filing: **16.02.2024**

(51) International Patent Classification (IPC):
***H10K 50/11*** *(2023.01)* ***H10K 50/16*** *(2023.01)*
***H10K 50/15*** *(2023.01)* *H10K 101/00 (2023.01)*
*H10K 101/30 (2023.01)* *H10K 101/40 (2023.01)*

(52) Cooperative Patent Classification (CPC):
**H10K 50/11; H10K 50/15; H10K 50/16;**
H10K 85/20; H10K 85/615; H10K 85/622;
H10K 85/626; H10K 85/631; H10K 85/633;
H10K 85/636; H10K 85/654; H10K 85/6572;
H10K 2101/00; H10K 2101/30; H10K 2101/40

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.02.2023 JP 2023027061**
**31.01.2024 JP 2024012856**

(71) Applicant: **CANON KABUSHIKI KAISHA**
**Tokyo 146-8501 (JP)**

(72) Inventors:
- **OHRUI, Hiroki**
  **Tokyo, 146-8501 (JP)**
- **NISHIDE, Yosuke**
  **Tokyo, 146-8501 (JP)**
- **TAKAYA, Itaru**
  **Tokyo, 146-8501 (JP)**

(74) Representative: **TBK**
**Bavariaring 4-6**
**80336 München (DE)**

# (54) ORGANIC LIGHT EMITTING ELEMENT

(57) An organic light emitting element that includes an anode (2), a cathode (9), a first organic compound layer (4), a light emission layer (5) containing a host material and a light emitting dopant material, and a second organic compound layer (6). The relationships concerning HOMO levels and LUMO levels of the host material and the light emitting dopant material in the light emission layer (5) are specified, and the materials for these layers are selected so that the hole mobility of the first organic compound layer (4) is equal to or greater than the electron mobility of the second organic compound layer (6).

FIG. 1B

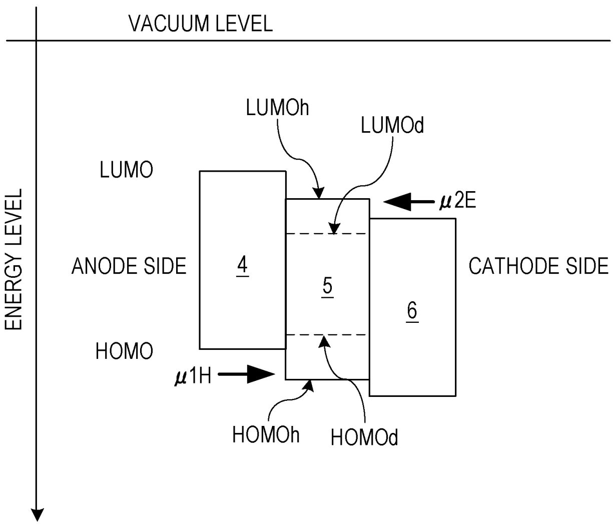


EP 4 422 371 A1

## Description

BACKGROUND OF THE INVENTION

Field of the Invention

The present disclosure relates to an organic light emitting element, and various appliances and apparatuses that include the organic light emitting element.

Description of the Related Art

An organic light emitting element (hereinafter, also referred to as an "organic electroluminescence element" or an "organic EL element") is an electronic element that includes a pair of electrodes and an organic compound layer disposed between these electrodes. By injecting electrons and holes from the pair of electrodes, excitons of a light emitting organic compound in the organic compound layer are generated, and the organic light emitting element emits light as the excitons return to the ground state.

Recent advancement in organic light emitting elements has been remarkable, enabling low drive voltage, a wide variety of emission wavelengths, high-speed responsivity, and thickness and weight reduction of light emitting devices. However, presently, the light emission efficiency and the continuous driving lifetime of the organic light emitting element are not practically sufficient for the element to be used as a light emitting device such a display, and higher light emission efficiency and improved continuous driving lifetime are desirable.

Regarding the improvement of the continuous driving lifetime of the organic light emitting element, Japanese Patent Laid-Open No. 2006-270091 focuses on the relationship between the mobility of the light emission layer and the mobility of each of two layers adjacent to the anode side and the cathode side of the light emission layer and discloses an element featuring balancing the electrons and holes moving into the light emission layer.

Japanese Patent Laid-Open No. 2006-270091 suggests that the durability lifetime of a light emitting element is improved by balancing electrons and holes moving into the light emission layer, but this light emitting element has high driving voltage and is not practical.

SUMMARY OF THE INVENTION

The present disclosure addresses the issues described above and provides an organic light emitting element that is driven at low voltage and has excellent durability properties.

The present invention in its first aspect provides an organic light emitting element as specified in claims 1 to 8. The present invention in its second aspect provides a display apparatus as specified in claim 9. The present invention in its third aspect provides a photoelectric conversion apparatus as specified in claim 10. The present invention in its fourth aspect provides electronic equipment as specified in claim 11. The present invention in its fifth aspect provides a lighting apparatus as specified in claim 12. The present invention in its sixth aspect provides a moving body as specified in claim 13. The present invention in its seventh aspect provides an image forming apparatus as specified in claim 14.

Further features of the present disclosure will become apparent from the following description of exemplary embodiments with reference to the attached drawings.

BRIEF DESCRIPTION OF THE DRAWINGS

Fig. 1A is a schematic cross-sectional view of one embodiment of an organic light emitting element according to the present disclosure. Fig. 1B is an energy diagram schematically illustrating the energy levels of a light emission layer and adjacent layers in the organic light emitting element according to the present disclosure.

Fig. 2A is a schematic cross-sectional view of a pixel of a display apparatus according to one embodiment of the present disclosure. Fig. 2B is a schematic cross-sectional view of a display apparatus according to one embodiment of the present disclosure.

Fig. 3 is a schematic diagram of a display apparatus according to one embodiment of the present disclosure.

Fig. 4A is a schematic diagram of an imaging apparatus according to one embodiment of the preset disclosure. Fig. 4B is a schematic diagram of electronic equipment according to one embodiment of the present disclosure.

Fig. 5A is a schematic diagram of a display apparatus according to one embodiment of the present disclosure. Fig. 5B is a schematic diagram of a foldable display apparatus according to one embodiment of the present disclosure.

Fig. 6A is a schematic diagram of a lighting apparatus according to one embodiment of the present disclosure. Fig.

6B is a schematic diagram of an automobile that includes a vehicle lighting unit according to one embodiment of the present disclosure.

Fig. 7A is a schematic diagram illustrating one example of a wearable device according to one embodiment of the present disclosure. Fig. 7B is a schematic diagram illustrating one example of a wearable device according to one embodiment of the present disclosure equipped with an imaging apparatus.

Fig. 8A is a schematic diagram illustrating one example of an image forming apparatus according to one embodiment of the present disclosure, Fig. 8B is a schematic diagram illustrating one example of an exposure light source used therein, and Fig. 8C is a schematic diagram illustrating another example of an exposure light source used therein.

Fig. 9 is a schematic diagram illustrating one example of an exposure light source of an image forming apparatus according to one embodiment of the present disclosure.

Figs. 10A, 10B, and 10C are schematic diagrams illustrating one example of the exposure light source of the image forming apparatus according to one embodiment of the present disclosure.

DESCRIPTION OF THE EMBODIMENTS

An organic light emitting element according to the present disclosure includes an anode, a cathode, a light emission layer that is disposed between the anode and the cathode, contains a host material and a light emitting dopant material, and has an anode side facing the anode and a cathode side facing the cathode, a first organic compound layer in contact with the anode side of the light emission layer, and a second organic compound layer in contact with the cathode side of the light emission layer.

Furthermore, following formulae (1), (2-1), and (2-2) are satisfied.

$$\mu 1H \geq \mu 2E \qquad (1)$$

$$HOMOh < HOMOd \qquad (2\text{-}1)$$

$$LUMOh > LUMOd \qquad (2\text{-}2)$$

μ1H: the hole mobility of the first organic compound layer
μ2E: the electron mobility of the second organic compound layer
HOMOh: the HOMO level of the host material
LUMOh: the LUMO level of the host material
HOMOd: the HOMO level of the light emitting dopant material
LUMOd: the LUMO level of the light emitting dopant material

The features and embodiments of the present disclosure will now be described.

1. Formulae (1), (2-1), and (2-2) are satisfied.

First, description related to Figs. 1A and 1B is provided. Fig. 1A is a schematic cross-sectional view illustrating one example of an embodiment of the organic light emitting element of the present disclosure. As illustrated in Fig. 1A, in the present disclosure, at least a first organic compound layer 4, a light emission layer 5, and a second organic compound layer 6 are interposed between an anode 2 and a cathode 9. The light emission layer 5 contains a host material and a light emitting dopant material.

Fig. 1B is an energy diagram schematically illustrating the energy levels of the light emission layer 5, the first organic compound layer 4, and the second organic compound layer 6 according to the present disclosure. The first organic compound layer 4 is in contact with the anode side of the light emission layer 5, and the second organic compound layer 6 is in contact with the cathode side of the light emission layer 5.

HOMO is short for highest occupied molecular orbital, and the energy level thereof is referred to as a "HOMO level" or "HOMO". LUMO is short for lowest unoccupied molecular orbital and the energy level thereof is referred to as a "LUMO level" or "LUMO". The HOMO level and the LUMO level are negative values, and, when the magnitudes of the energy levels are expressed in the present disclosure, the levels that are coming closer to the vacuum level are referred to as high levels or increased levels, and the levels that are coming farther from the vacuum level are referred to as low levels or decreased levels.

Fig. 1B is a typical energy diagram in which the HOMO level of the first organic compound layer 4 is higher

than the HOMO level of the host material in the light emission layer 5 and in which the LUMO level of the second organic compound layer 6 is lower than the LUMO level of the host material in the light emission layer 5.

Since the first organic compound layer 4 has a function of an electron blocking layer, the LUMO level of the first organic compound layer 4 is higher than the LUMO level (LUMOh) of the host material, and, when the first organic compound layer 4 has a bandgap substantially the same as that of the host material, the HOMO level of the first organic compound layer 4 is naturally higher than the HOMO level (HOMOh) of the host material.

In contrast, since the second organic compound layer 6 has a function of a hole blocking layer, the HOMO level of the second organic compound layer 6 is lower than the HOMO level (HOMOh) of the host material, and, when the second organic compound layer 6 has a bandgap substantially the same as that of the host material, the LUMO level of the second organic compound layer 6 is naturally lower than the LUMO level (LUMOh) of the host material.

As mentioned above, according to the energy diagram illustrated in Fig. 1B, when the light emission layer 5 is solely composed of a host material, the relationships indicated by "HOMO level of first organic compound layer 4 > HOMO level of host material" and "LUMO level of second organic compound layer 6 < LUMO level of host material" are established, and due to these relationships, an injection barrier is present in injecting holes and electrons into the light emission layer 5 and thus higher voltage is needed.

When formula (2-1) and (2-2) above are satisfied in the light emission layer 5 as one of the features of the present disclosure, the barrier present during the injection of holes from the first organic compound layer 4 into the light emission layer 5 and the injection of electrons from the second organic compound layer 6 into the light emission layer 5 is alleviated, and thus low voltage is achieved. This is because some of holes and electrons are injected through the HOMO level (HOMOd) and the LUMO level (LUMOd) of the light emitting dopant material illustrated in Fig. 1B and thus the injection barrier is alleviated. To facilitate the injection through the LUMO level of the dopant material, the LUMO level of the dopant material can be lower than the LUMO level of the second organic compound layer 6. Likewise, to facilitate the injection through the HOMO level of the dopant material, the HOMO level of the dopant material can be higher than the HOMO level of the first organic compound layer 4. By employing one of these structures, the effect of voltage reduction is achieved, and by employing both structures, a more preferable embodiment is created.

When the relationship indicated by formula (1) above as well as the relationships indicated by formulae (2-1) and (2-2) are satisfied, the proportion in which the region (hereinafter this region is referred to as the "exciton generating region") where excitons are generated due to recombination of holes and electrons in the light emission layer 5 occupies the second organic compound layer 6-side portion of the light emission layer 5 increases, deterioration of the light emission layer 5 is alleviated, and thus the lifetime of the organic light emitting element can be extended.

The proportion in which the exciton generating region in the light emission layer 5 occupies the vicinity of the first organic compound layer 4-side interface or the second organic compound layer 6-side interface is typically attributable to the balance between the hole mobility and the electron mobility in the light emission layer 5 in most cases. Meanwhile, when the hole mobility and the electron mobility are about the same, the exciton generating region in the light emission layer 5 is affected by the hole mobility ($\mu$1H) of the first organic compound layer 4 adjacent to the light emission layer 5 and the electron mobility ($\mu$2E) of the second organic compound layer 6 adjacent to the light emission layer 5. Here, by satisfying the relationship indicated by formula (1), the hole mobility of the first organic compound layer 4 is faster than the electron mobility of the second organic compound layer 6, and thus the proportion in which the exciton generating region occupies the second organic compound layer 6-side portion in the light emission layer 5 increases.

In general, the first organic compound layer 4 is composed of an amine skeleton-containing material, and, as described below, the amine skeleton-containing material is unstable in terms of bonding energy; thus, when the proportion in which the recombination region occupies the first organic compound layer 4-side portion of the light emission layer 5 increases, deterioration of the light emission layer 5 is prone to occur. Here, in such a case, the probability of electron injection from the light emission layer 5 into the first organic compound layer 4 increases, but since the first organic compound layer 4 is unstable against electrons, there is a high possibility that the first organic compound layer 4 would deteriorate.

Meanwhile, in general, the second organic compound layer 6 can be composed of a hydrocarbon, which is stable in terms of bonding energy. Thus, when the proportion in which the recombination region occupies the second organic compound layer 6-side portion increases, there is a possibility that hole injection would occur from the light emission layer 5 into the second organic compound layer 6; however, in such a case also, the possibility of deterioration of the second organic compound layer 6 is low since the second organic compound layer 6 is chemically stable against the holes.

As such, since the second organic compound layer 6 can be composed of a highly chemically stable material, by satisfying the relationship indicated by formula (1), the proportion in which the exciton generating region in the light emission layer 5 occupies the second organic compound layer 6-side portion increases, and deterioration of the light emission layer 5 is reduced. Thus, the lifetime of the organic light emitting element can be extended at the same time as achieving low voltage when the relationships indicated by formulae (1), (2-1), and (2-2) are satisfied.

The organic light emitting element according to the present disclosure can have following features 2 to 6.

2. The light emission layer satisfies the relationships indicated by formulae (3-1) and (3-2) below.

$$\text{HOMOd - HOMOh} \geq 0.15 \text{ eV} \qquad (3\text{-}1)$$

$$\text{LUMOh - LUMOd} \geq 0.15 \text{ eV} \qquad (3\text{-}2)$$

By satisfying the relationships indicated by formulae (3-1) and (3-2), the hole injectability from the first organic compound layer 4 into the light emission layer 5 and the electron injectability from the second organic compound layer 6 into the light emission layer 5 are improved and, in addition, the holes and electrons injected into the light emission layer 5 become trapped in the light emission layer 5, leakage of holes to the second organic compound layer 6 and electrons to the first organic compound layer 4 can be reduced. As a result, the hole-electron recombination probability is improved, the exciton generating probability is improved, and thus the light emission efficiency of the organic light emitting element can be improved.

Furthermore, by satisfying the relationships indicated by formulae (3-1) and (3-2), the light emission efficiency is improved and, in addition, the hole mobility and the electron mobility in the light emission layer 5 become substantially the same. Thus, although the exciton generating region in the light emission layer 5 is affected by the hole mobility of the first organic compound layer 4 adjacent to the light emission layer 5 and the electron mobility of the second organic compound layer 6 adjacent to the light emission layer 5, the lifetime of the light emitting element can be extended as described above since the relationship indicated by formula (1) is satisfied.

3. The host material and the light emitting dopant material are hydrocarbons.

The host material and the light emitting dopant material of the present disclosure can each have a molecular structure that can withstand excessive radical cation generation, and can be highly chemically stable hydrocarbons. A hydrocarbon is a compound that does not have a bond with low bonding stability within its molecular structure, and thus, when the element is driven, the compound rarely undergoes deterioration due to driving, and the lifetime of the organic light emitting element is long. A bond with low bonding stability in the molecular structure refers to a bond, such as an amino group, that has relatively low bonding energy and is unstable.

Bonds with low bonding stability in compounds A-1, A-2, and B-1 described below are a bond between a carbazole ring and a phenylene group and a bond between an amino group and a phenyl group (nitrogen-carbon bonds). A bond between carbons, such as that in compound B-1, has higher bonding stability.

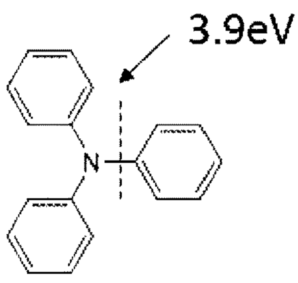


A-1

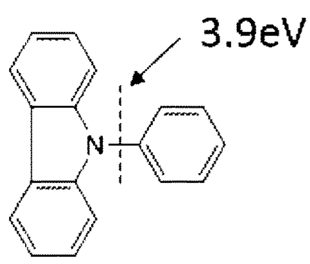


A-2

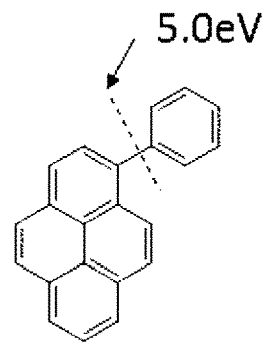


B-1

Here, calculation was performed by b3-lyp/def2-SV(P).

A density functional theory (DFT) currently widely used is employed as the molecular orbital calculation technique. B3LYP was used as the functional, and 6-31G* was used as the base function. The molecular orbital calculation was performed by Gaussian09 (Gaussian 09, Revision C.01, M. J. Frisch, G. W. Trucks, H. B. Schlegel, G. E. Scuseria, M. A. Robb, J. R. Cheeseman, G. Scalmani, V. Barone, B. Mennucci, G. A. Petersson, H. Nakatsuji, M. Caricato, X. Li, H. P. Hratchian, A. F. Izmaylov, J. Bloino, G. Zheng, J. L. Sonnenberg, M. Hada, M. Ehara, K. Toyota, R. Fukuda, J. Hasegawa, M. Ishida, T. Nakajima, Y. Honda, O. Kitao, H. Nakai, T. Vreven, J. A. Montgomery, Jr., J. E. Peralta, F. Ogliaro, M. Bearpark, J. J. Heyd, E. Brothers, K. N. Kudin, V. N. Staroverov, T. Keith, R. Kobayashi, J. Normand, K. Raghavachari, A. Rendell, J. C. Burant, S. S. Iyengar, J. Tomasi, M. Cossi, N. Rega, J. M. Millam, M. Klene, J. E. Knox, J. B. Cross, V. Bakken, C. Adamo, J. Jaramillo, R. Gomperts, R. E. Stratmann, O. Yazyev, A. J. Austin, R. Cammi, C. Pomelli, J. W. Ochterski, R. L. Martin, K. Morokuma, V. G. Zakrzewski, G. A. Voth, P. Salvador, J. J. Dannenberg, S. Dapprich, A. D. Daniels, O. Farkas, J. B. Foresman, J. V. Ortiz, J. Cioslowski, and D. J. Fox, Gaussian, Inc., Wallingford

CT, 2010.) that is currently widely implemented.

These results indicate that the host material and the light emitting dopant material in the light emission layer of the present disclosure can be hydrocarbons. Specifically, for example, benzene, naphthalene, fluorene, benzofluorene, phenanthrene, chrysene, triphenylene, pyrene, perylene, fluoranthene, and benzofluoranthene have high intramolecular bonding energy since there are up to two benzene rings that are fused linearly.

4. The host material includes a perylene skeleton in its molecular structure.

As described in 3 above, the host material can be a hydrocarbon having high chemical stability and, in particular, can be a fused polycycle having a particularly narrow bandgap. Due to formulae (2-1) and (2-2), some of holes and electrons are injected through the HOMO level and the LUMO level of the light emitting dopant material and thus the injection barrier is alleviated; however, most of holes and electrons are directly injected to the HOMO level and the LUMO level of the host material. Thus, by selecting a material with a narrow bandgap as the host material, the hole injectability from the first organic compound layer 4 to the light emission layer 5 and the electron injectability from the second organic compound layer 6 to the light emission layer 5 are improved, and the voltage can be further decreased.

Specific examples of the fused polycycles of hydrocarbons with narrow bandgaps include, but are not limited to, the following. In particular, those which have structures represented by H1 to H12 having perylene skeletons are particularly preferable.

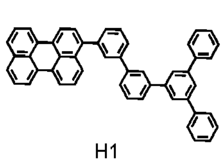
H1
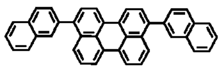
H2
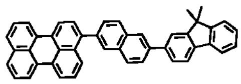
H3
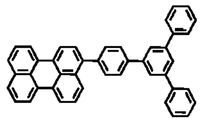
H4

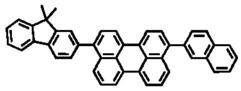
H5
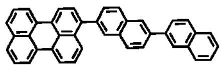
H6
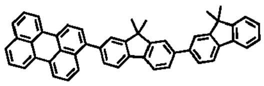
H7
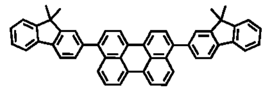
H8

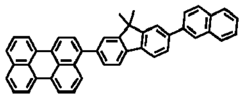
H9
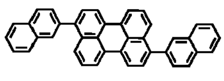
H10
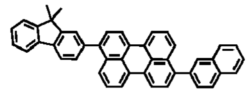
H11
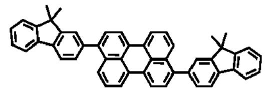
H12

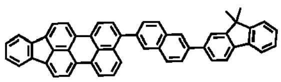
H13
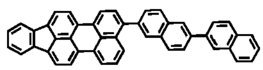
H14
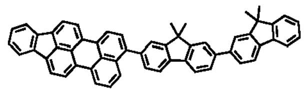
H15
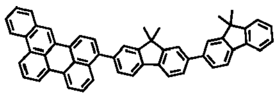
H16

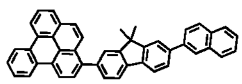
H17
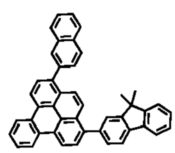
H18
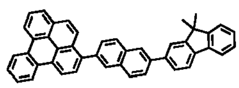
H19
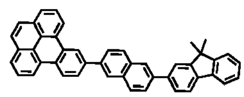
H20

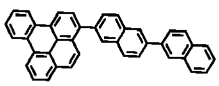
H21
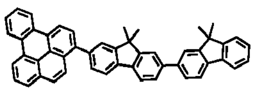
H22
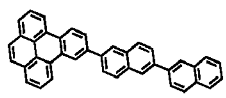
H23
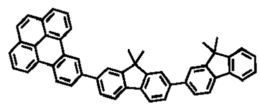
H24

5. Emission color is red.

The emission color of the organic light emitting element of the present disclosure can be red. This is because when the host material is a highly chemically stable hydrocarbon and can have a narrow bandgap and a perylene

skeleton, the light emitting dopant material can be a long-wavelength red light emitting material having a narrow bandgap in order to satisfy the relationships indicated by formulae (3-1) and (3-2).

Specific examples of the light emitting dopant are as follows.

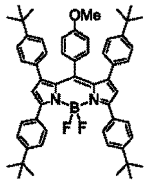
RD1
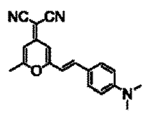
RD2
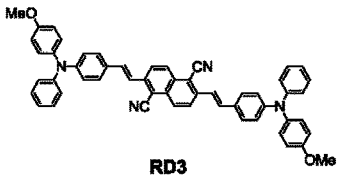
RD3
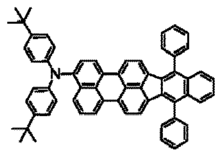
RD4

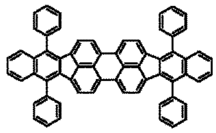
RD5
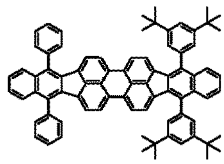
RD6
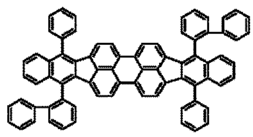
RD7
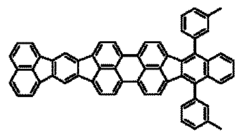
RD8

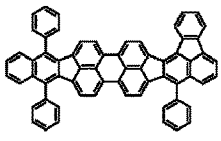
RD9
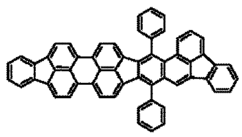
RD10
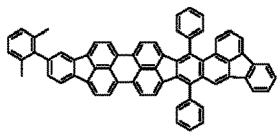
RD11
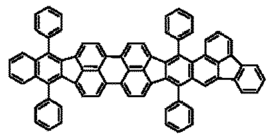
RD12

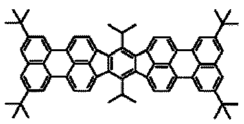
RD13
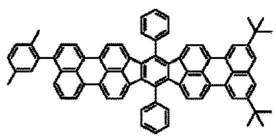
RD14
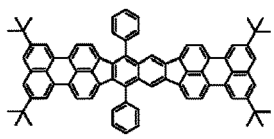
RD15

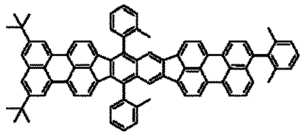
RD16
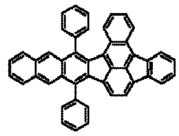
RD17
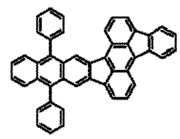
RD18
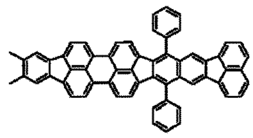
RD19

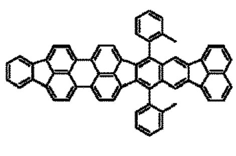
RD20
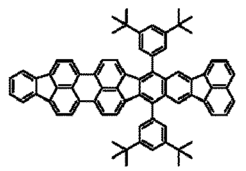
RD21
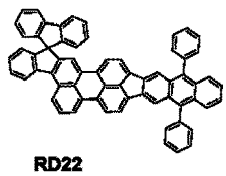
RD22
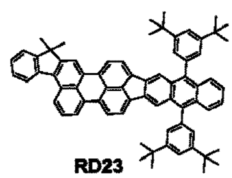
RD23

6. The second organic compound layer consists of a hydrocarbon.

For the same reasons as those described in 3 above, the second organic compound layer can also consist of a highly chemically stable hydrocarbon.

7. The electron mobility μ2E of the second organic compound layer is 1 × $10^{-3}$ $cm^2$/Vs or less, and a pyrene skeleton or a fluoranthene skeleton is contained in the molecular structure.

The second organic compound layer 6 can be composed of a fused polycycle having an electron mobility μ2E of 1 × $10^{-3}$ $cm^2$/Vs or less, and, specifically, can be composed of a material that contains a pyrene skeleton or a fluoranthene skeleton in its molecular structure. Thus, the first organic compound layer 4 can be composed of a material

having a hole mobility μ1H of $1 \times 10^{-3}$ $cm^2/Vs$ or less.

Specific examples of the material constituting the second organic compound layer 6 are described below, among which AD-1 to AD-12 having an electron mobility μ2E of $1 \times 10^{-4}$ $cm^2/Vs$ or more and $1 \times 10^{-3}$ $cm^2/Vs$ or less are preferable.

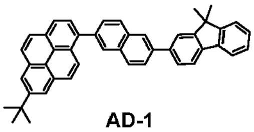
AD-1

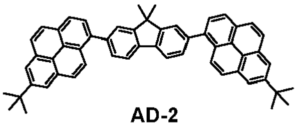
AD-2

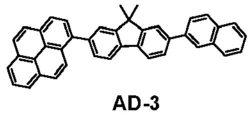
AD-3

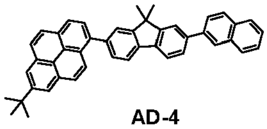
AD-4

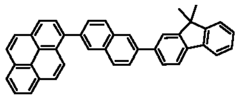
AD-5

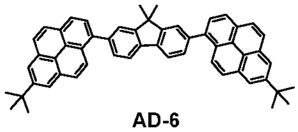
AD-6

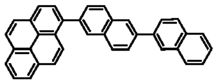
AD-7

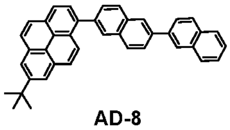
AD-8

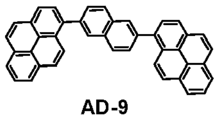
AD-9

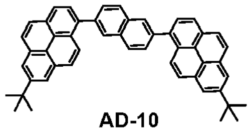
AD-10

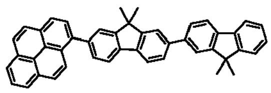
AD-11

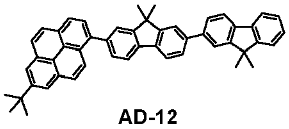
AD-12

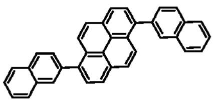
AD-13

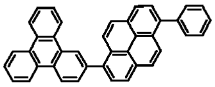
AD-14

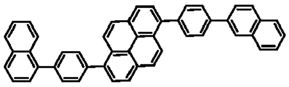
AD-15

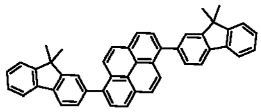
AD-16

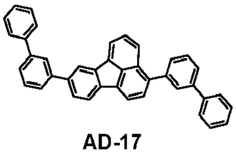
AD-17

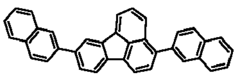
AD-18

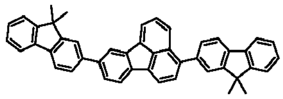
AD-19

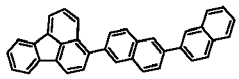
AD-20

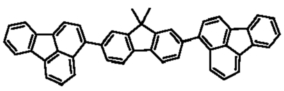
AD-21

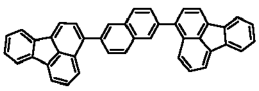
AD-22

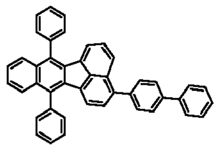
AD-23

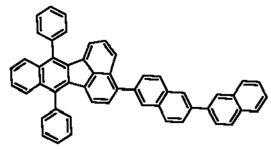
AD-24

Other features of the organic light emitting element

An organic light emitting element is typically obtained by forming an insulating layer, a first electrode, an organic compound layer, and a second electrode on a substrate. A protection layer, a color filter, a microlens, etc., may be formed on the second electrode. When a color filter is to be formed, a planarization layer may be formed between the color filter and the protection layer. The planarization layer can be formed by using an acrylic resin or the like. The same applies to the case in which a planarization layer is formed between a color filter and a microlens.

The features of the organic light emitting element of the present disclosure other than the light emission layer and the second organic compound layer will now be described.

Substrate

The organic light emitting element of the present disclosure may be formed on a substrate, and examples of the substrate include quartz, glass, a silicon wafer, a resin, and a metal. Switching elements such as transistors and lines may be disposed on the substrate, and an insulating layer may be disposed thereon. The material for the insulating layer may be any as long as contact holes that can form lines to the first electrode can be formed and the insulation

from the lines not to be connected can be secured. For example, resins such as polyimide, silicon oxide, or silicon nitride can be used.

Electrode

The organic light emitting element includes a pair of electrodes, and, when an electric field is applied in a direction in which the organic light emitting element emits light, the electrode with a higher potential is the anode, and the other electrode is the cathode. This can also be rephrased as that the electrode that supplies holes to the light emission layer is the anode, and the electrode that supplies electrons is the cathode. In the present disclosure, one of the anode and the cathode may be a first electrode (substrate-side electrode). Typically, as illustrated in Fig. 1A, the anode 2 is arranged on the substrate 1 side, but this is not limiting.
The material constituting the anode can have a work function as large as possible. Examples of such a material that can be used include single metals such as gold, platinum, silver, copper, nickel, palladium, cobalt, selenium, vanadium, and tungsten, mixtures thereof, and alloys thereof; and metal oxides such as tin oxide, zinc oxide, indium oxide, indium tin oxide (ITO), and indium zinc oxide. In addition, conductive polymers such as polyaniline, polypyrrole, and polythiophene can be used.
These electrode substances may be used alone or two or more of these substances may be used in combination. The anode may be constituted by a single layer or multiple layers.
For use as a reflection electrode, chromium, aluminum, silver, titanium, tungsten, molybdenum, an alloy thereof, or a layered product thereof can be used. A reflection film that does not function as an electrode can also be made by using the aforementioned material. For use as a transparent electrode, an oxide transparent conductive layer such as indium tin oxide (ITO) or indium zinc oxide can be used, but this is not limiting. Photolithography can be employed to form electrodes.
In contrast, the material constituting the cathode can have a small work function. Examples of such a material include alkali metals such as lithium, alkaline earth metals such as calcium, single metals such as aluminum, titanium, manganese, silver, lead, and chromium, and mixtures thereof. In addition, alloys of these single metals can also be used. For example, magnesium-silver, aluminum-lithium, aluminum-magnesium, silver-copper, and zinc-silver can be used. Metal oxides such as indium tin oxide (ITO) can also be used. These electrode substances may be used alone or two or more of these substances may be used in combination. The cathode may have a single layer structure or a multilayer structure. In particular, silver is preferably used, and, in order to decrease aggregation of silver, silver alloys are more preferably used. The alloying ratio may be any as long as aggregation of silver can be decreased. For example, the silver-to-other metal ratio may be 1:1, 3: 1, or the like.
The cathode is not particularly limited, for example, an oxide conductive layer such as ITO can be used as the cathode to form a top-emission element, or aluminum (Al) or the like can be used in the cathode to function as a reflection electrode so as to form a bottom-emission element. The method for forming the cathode may be any; however, DC or AC sputtering achieves good film coverage and easily decreases the resistance.

Organic compound layers

As illustrated in Fig. 1A, the organic light emitting element of the present disclosure includes the hole injection layer 3, the electron transport layer 7, the electron injection layer 8, etc., but these layers are optional and any of these layers may include multiple layers. Furthermore, although these are examples of the organic compound layers, these layers may be composed of inorganic compounds.
Furthermore, various layer configurations may be employed, such as providing an insulating layer at the interface between an electrode and an organic compound layer, providing an adhesion layer or an interference layer, and forming the electron transport layer 7 or the first organic compound layer 4 by using two layers with different ionization potentials.
The organic compound layers may be formed as common layers for multiple organic light emitting elements. A common layer is a layer that straddles over multiple organic light emitting elements, and can be formed by performing a coating method such as spin coating or a vapor deposition method on the entire surface of the substrate.
Examples of the materials therefor are as follows. Examples of the material used in the first organic compound layer 4 include materials that facilitate injection of holes from the anode 2 and materials having high hole mobility capable of transporting injected holes to the light emission layer. The same material can be used in the hole injection layer 3.
In order to reduce degradation of the film quality, such as crystallization, in the organic light emitting element, a material with a high glass transition point can be used. Examples of low-molecular-weight and high-molecular-weight materials with high hole mobility include triarylamine derivatives, arylcarbazole derivatives, phenylenediamine derivatives, stilbene derivatives, phthalocyanine derivatives, porphyrin derivatives, poly(vinylcarbazole), poly(thiophene), and other conductive polymers.
Specific examples of the material used in the first organic compound layer 4 are described in HT1 to HT9 below,

but these examples are not limiting.

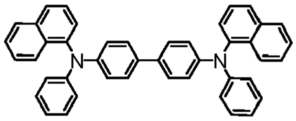

HT1

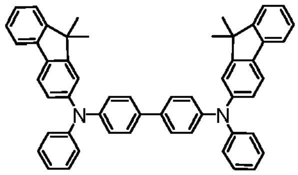

HT2

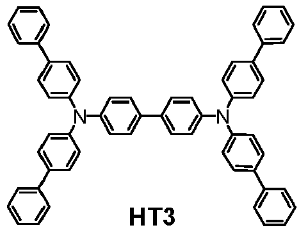

HT3

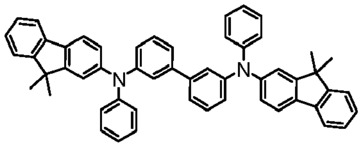

HT4

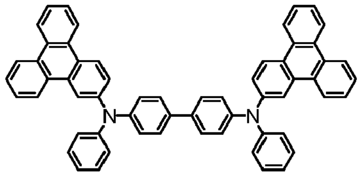

HT5

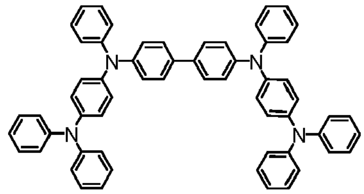

HT6

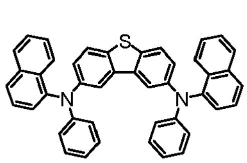

HT7

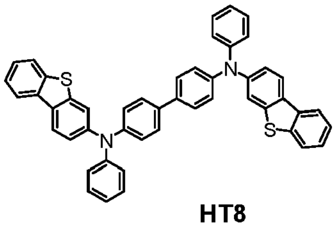

HT8

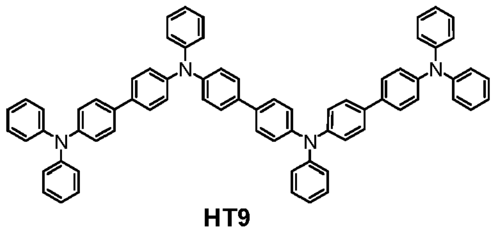

HT9

In the hole injection layer 3, a compound having a deep LUMO level, such as a hexaazatriphenylene compound, a tetrafluoroquinodimethane compound, or a dichlorodicyanobenzoquinone compound, can be used. Specific examples thereof include compounds HT10 to HT13 described below.

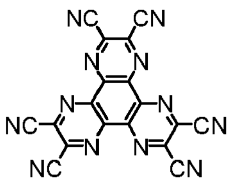

HT10

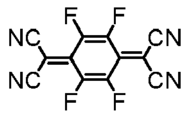

HT11

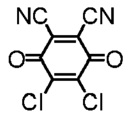

HT12

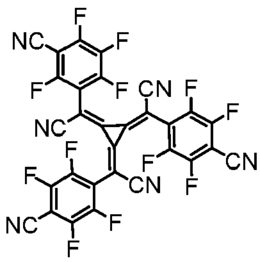

HT13

The material for the electron transport layer 7 can be freely selected from those which can transfer electrons to the light emission layer, and is selected by considering the balance with the hole mobility of the hole transport material, etc.

Examples of the material having the electron transport capacity include oxadiazole derivatives, oxazole derivatives, pyrazine derivatives, triazole derivatives, triazine derivatives, quinoline derivatives, quinoxaline derivatives, phenanthroline derivatives, and organoaluminum complexes.

Specific examples of the material used in the electron transport layer 7 are described in ET1 to ET23 below, but these examples are not limiting. A material, such as ET1 to ET7, that has a phenanthroline or pyridine skeleton can be used in the electron transport layer 7. This is because such a material interacts with an electron injection material such as an alkali metal compound or an electrode material and thus has an effect of decreasing the electron injection barrier.

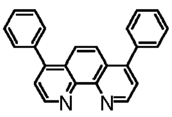
ET1
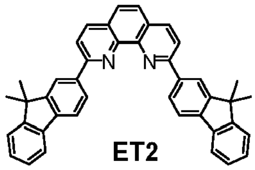
ET2
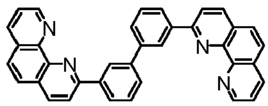
ET3
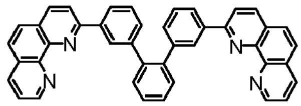
ET4

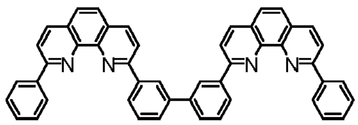
ET5
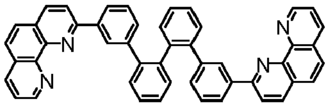
ET6
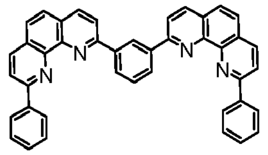
ET7

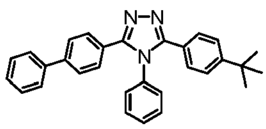
ET8
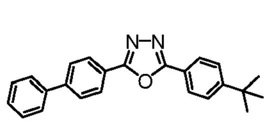
ET9
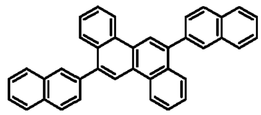
ET10
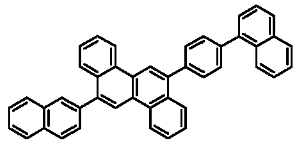
ET11

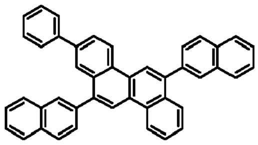
ET12
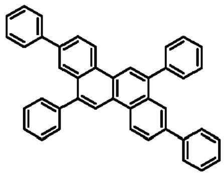
ET13
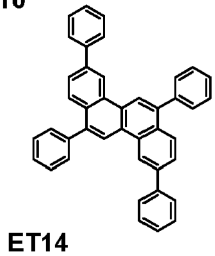
ET14
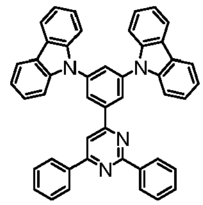
ET15

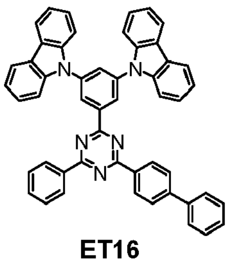
ET16
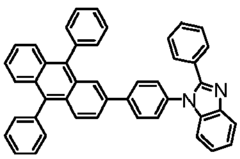
ET17
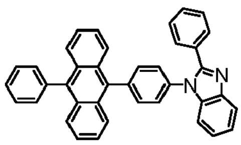
ET18
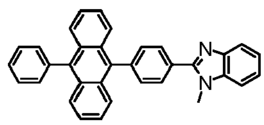
ET19

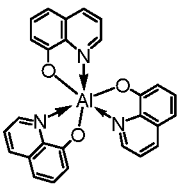
ET20
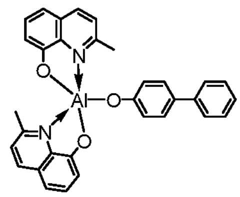
ET21
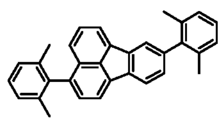
ET22
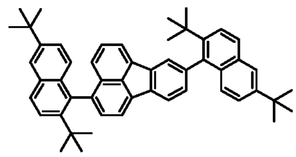
ET23

In the present disclosure, the electron injection layer 8 may be included. Any commonly known material can be used in the electron injection layer 8, and examples thereof include alkali metals, alkaline earth metals, rare earth metals, and compounds thereof. Specifically, metallic Ca, LiF, KF, $Cs_2CO_3$, or the like is used, and a mixture of any of these with the aforementioned electron transport materials may be used.

The organic compound layers constituting the organic light emitting element of the present disclosure can be formed by a dry process such as a vacuum deposition method, an ionized deposition method, sputtering, or plasma. Instead of the dry process, a wet process can be employed to form layers by a known coating method (for example, spin coating, dip coating, casting, a LB method, or an inkjet method) that involves dissolving the material in an appropriate solvent.

Here, when layers are formed by a vacuum deposition method or a solution coating method, for example,

crystallization rarely occurs, and stability over time is improved. When films are formed by a coating method, an appropriate binder resin may be used in combination to form the films.

Examples of the binder resin include, but are not limited to, polyvinyl carbazole resin, polycarbonate resin, polyester resin, ABS resin, acrylic resin, polyimide resin, phenolic resin, epoxy resin, silicone resin, and urea resin.

These binder resins may be used alone as a homopolymer or in combination as a mixture of two or more to form a copolymer. If necessary, additives such as known plasticizers, oxidation inhibitors, and ultraviolet absorbents may be used in combination.

Protection layer

A protection layer may be formed on the second electrode. For example, by bonding a hygroscopic agent-laden glass onto the second electrode, penetration of water and the like into organic compound layers can be reduced, and the incidence of display failures can be decreased. In another embodiment, a passivation film such as silicon nitride film may be disposed on the second electrode so as to reduce penetration of water and the like into the organic compound layers. For example, after the second electrode is formed, the second electrode may be transported to another chamber without breaking the vacuum, and then a silicon nitride film having a thickness of 2 μm may be formed thereon by a CVD method to form a protection layer. Alternatively, after film deposition by a CVD method, a protection layer may be formed by an atomic layer deposition (ALD) method. The material for the film formed by the ALD method is not particularly limited and can be silicon nitride, silicon oxide, or aluminum oxide, for example. Silicon nitride may be further formed by a CVD method on the film formed by an ALD method. The film formed by the ALD method may be thinner than the film formed by the CVD method. Specifically, the thickness may be 50% or less or even 10% or less.

Color filter

A color filter may be formed on the protection layer. For example, a color filter that takes into account the size of the organic light emitting element may be disposed on a separate substrate, and this substrate may be bonded with the substrate on which the organic light emitting element has been formed, or a color filter may be formed by photolithographic patterning on the aforementioned protection layer. The color filter may be composed of a polymer.

Planarization layer

A planarization layer may be disposed between the color filter and the protection layer. The planarization layer is formed for the purpose of decreasing the irregularities of the underlying layer. Such a layer may also be referred to as a material resin layer without limiting the purpose. The planarization layer may be composed of an organic compound and may have a low molecular weight or a high molecular weight, preferably, a high molecular weight.

Planarization layers may be disposed above and under the color filter, and in such a case, the materials constituting the planarization layers may be the same or different. Specific examples thereof include polyvinyl carbazole resin, polycarbonate resin, polyester resin, ABS resin, acrylic resin, polyimide resin, phenolic resin, epoxy resin, silicone resin, and urea resin.

Microlens

An organic light emitting element or an organic light emitting apparatus that includes the organic light emitting element may include an optical member, such as a microlens, on the light incident side thereof. The microlens can be composed of an acrylic resin, an epoxy resin, or the like. The microlens may be provided for the purposes of increasing the amount of light emerging from the organic light emitting element or the organic light emitting apparatus and controlling the direction in which the light emerges. The microlens may have a hemispherical shape. When the microlens has a hemispherical shape, there are tangent lines that contact the hemisphere, among which there is a tangent line parallel to the insulating layer, and the point of contact between that tangent line and the hemisphere is the apex of the microlens. The apex of the microlens can also be determined in the same manner from any cross-sectional view thereof. In other words, among the tangent lines that contact the semicircle of the microlens in a cross-sectional view, there is a tangent line parallel to the insulating layer, and the point of contact between that tangent line and the semicircle is the apex of the microlens.

Furthermore, the midpoint of the microlens can be defined. In a cross section of the microlens, a line segment extending from a point where the shape or an arc ends to another point where the shape of the arc ends is hypothetically drawn, and the midpoint of that line segment can be called the midpoint of the microlens. The cross section used to determine the apex and the midpoint may be a cross section perpendicular to the insulating layer.

Counter substrate

A counter substrate may be provided on the planarization layer. The counter substrate is called a counter substrate since the counter substrate is disposed at a position opposing the aforementioned substrate. The material constituting the counter substrate may be the same as the aforementioned substrate. The counter substrate may be a second substrate provided that the aforementioned substrate is a first substrate.

Pixel circuit

An organic light emitting apparatus that includes an organic light emitting element may include a pixel circuit connected to the organic light emitting element. The pixel circuit may be of an active matrix type that independently controls light emission of a first light emitting element and a second light emitting element. The active matrix circuit may be voltage-programmed or current-programmed. The drive circuit has a pixel circuit for each pixel. The pixel circuit may include a light emitting element, a transistor that controls the emission luminance of the light emitting element, a transistor that controls the light emission timing, a capacitor that retains the gate voltage of the transistor that controls the emission luminance, and a transistor for establishing the connection to GND without a light emitting element.

The light emitting apparatus has a display region and a peripheral region around the display region. The display region includes pixel circuits, and the peripheral region includes display control circuits. The mobility of the transistor constituting the pixel circuit may be smaller than the mobility of the transistor constituting the display control circuit. The gradient of the current-voltage characteristic of the transistor constituting the pixel circuit may be smaller than the gradient of the current-voltage characteristic of the transistor constituting the display control circuit. The gradient of the current-voltage characteristic can be measured by what is commonly known as Vg-Ig characteristics. The transistor constituting the pixel circuit is a transistor connected to a light emitting element, such as a first light emitting element.

Pixels

The organic light emitting apparatus that includes the organic light emitting element may include multiple pixels. Each pixel has subpixels that emit light of colors different from one another. The subpixels may emit light of RGB colors, for example.

The pixel has a region also known as a pixel aperture that emits light. The pixel aperture may be 15 μm or less or 5 μm or more. More specifically, the pixel aperture may be, for example, 11 μm, 9.5 μm, 7.4 μm, or 6.4 μm. The distance between subpixels may be 10 μm or less, specifically, 8 μm, 7.4 μm, or 6.4 μm.

The pixels may be arranged into any known pixel matrix in a plan view. Examples thereof include a stripe matrix, a delta matrix, a pentile matrix, and a bayer matrix. The shape of the subpixels in a plan view may be any known shape. Examples thereof include rectangular shapes such as an oblong shape or a rhombus shape, and hexagonal shapes. Naturally, the shape does not have to be exact, and any shape close to an oblong shape is considered an oblong shape. The shape of the subpixels and the pixel arrangement may be used in combination.

Usage of organic light emitting element

The organic light emitting element according to the present disclosure can be used as a member that constitutes a display apparatus or a lighting apparatus. Other examples of the usage include an exposure light source of an electrophotographic image forming apparatus, a backlight of a liquid crystal display apparatus, and a light emitting apparatus that has a color filter on a white light source.

The display apparatus may be an information processing apparatus that includes an image input unit through which image information is input from an area CCD, a linear CCD, a memory card, or the like, and an information processing unit that processes the input information, and that displays the input image on a display unit. The display apparatus may include multiple pixels, and at least one of the pixels may include the organic light emitting element of the present embodiment and a transistor connected to the organic light emitting element.

Furthermore, a display unit of an imaging apparatus or an ink jet printer may have a touch panel function. The driving system of the touch panel function may be infrared radiation, electrostatic capacitance, resistance film, electromagnetic induction, or any other system. The display apparatus may be used in a display unit of a multifunctional printer.

Next, a display apparatus according to one embodiment is described with reference to the drawings.

Fig. 2A and 2B are schematic cross sectional views illustrating examples of a display apparatus that includes organic light emitting elements of the present disclosure and transistors connected to the organic light emitting elements.

Fig. 2A illustrates one example of a pixel which is a constitutional feature of the display apparatus of this embodiment. The pixel has subpixels 20. The subpixels are classified as 20R, 20G, and 20B according to their emission color. The emission color may be distinguished by the wavelength of the light emitted from the light emission layer, or

a color filter or the like may be used to selectively transmit or change the color of the light emitted from the subpixels. Each of the subpixels has a first electrode 12 that serves as a reflection electrode disposed on an interlayer insulating layer 11, an insulating layer 13 that covers edges of the first electrode 12, an organic compound layer 14 that covers the first electrode 12 and the insulating layer 13, a second electrode 15, a protection layer 16, and a color filter 17. The first electrode 12, the organic compound layer 14, and the second electrode 15 constitute an organic light emitting element 18 of this embodiment.

The interlayer insulating layer 11 may have a transistor and a capacitor element below or inside thereof. The transistor and the first electrode 12 may be electrically connected to each other via a contact hole or the like not illustrated in the drawing.

The insulating layer 13 is also referred to as a bank or a pixel isolation film. The insulating layer 13 covers the edges of the first electrode 12 and surrounds the first electrode 12. The part where the insulating layer 13 is absent is in contact with the organic compound layer 14 and functions as a light-emitting region.

The second electrode 15 may be a transparent electrode, a reflection electrode, or a semi-transmissive electrode.

The protection layer 16 reduces penetration of moisture into the organic compound layer 14. Although the protection layer 16 is depicted as one layer in the drawing, the protection layer 16 may include multiple layers. An inorganic compound layer and an organic compound layer may be provided for each layer.

The color filters 17 are classified as 17R, 17G, and 17B according to their colors. The color filters may be formed on a planarizing film not illustrated in the drawing. A resin protection layer not illustrated in the drawing may be disposed on the color filters. The color filters 17 may be formed on the protection layer 16. Alternatively, the color filters 17 may be formed on a counter substrate such as a glass substrate and then bonded with the substrate.

A display apparatus illustrated in Fig. 2B includes an organic light emitting element 36 and a TFT 28 as one example of the transistor. Specifically, there are a substrate 21, such as glass or silicon, and an insulating layer 22 on top of the substrate 21, and a TFT 28 that includes a gate electrode 23, a gate insulating film 24, a semiconductor layer 25, a drain electrode 26, and a source electrode 27 is disposed on the insulating layer 22. An insulating film 29 is disposed on top of the TFT 28, and a contact hole 30 formed in the insulating film 29 connects an anode 31 of the organic light emitting element 36 to the source electrode 27.

Here, the type of electrical connection between the electrodes (anode 31 and cathode 33) included in the organic light emitting element 36 and the electrodes (source electrode 27 and drain electrode 26) included in the TFT 28 is not limited to the one illustrated in Fig. 2B. In other words, the type of electrical connection may be any as long as one of the anode 31 and the cathode 33 is electrically connected to one of the source electrode 27 and the drain electrode 26. The TFT 28 is a thin film transistor.

A first protection layer 34 and a second protection layer 35 are disposed on the cathode 33 to reduce deterioration of the organic light emitting element.

The emission luminance of the organic light emitting element 36 of the present embodiment is controlled by the TFT 28, and, by providing multiple organic light emitting elements 36 in-plane, an image can be displayed by using emission luminance.

The display apparatus illustrated in Fig. 2B uses a transistor as a switching element, but may use a different switching element instead.

The transistor used in the display apparatus illustrated in Fig. 2B is not limited to a TFT having an active layer on an insulating surface of a substrate and may be a transistor that uses a single-crystal silicon wafer. The active layer may be a non-single-crystal silicon such as amorphous silicon or microcrystalline silicon, or a non-single-crystal oxide semiconductor such as indium zinc oxide or indium gallium zinc oxide.

Alternatively, a transistor made of a low-temperature polysilicon or an active matrix driver formed on a substrate such as a Si substrate may be used. The phrase "on the substrate" can also mean "in the substrate". Whether a transistor is formed in the substrate or a TFT is used is selected according to the size of the display unit; for example, when the size is about 0.5 inches, organic light emitting elements may be formed on a Si substrate. Here, the phrase "formed in the substrate" means that the transistor is produced by processing a substrate, such as a Si substrate, itself. In other words, "transistor in the substrate" can also be considered as that the substrate and the transistor are integrated.

Fig. 3 is a schematic diagram illustrating one example of the display apparatus according to the present disclosure. A display apparatus 1000 includes an upper cover 1001 and a lower cover 1009, and a touch panel 1003, a display panel 1005, a frame 1006, a circuit substrate 1007, and a battery 1008 that are interposed between these covers. The touch panel 1003 and the display panel 1005 are respectively connected to flexible print circuits FPC 1002 and 1004. Transistors are printed on the circuit substrate 1007. When the display apparatus is not a portable appliance, the battery 1008 may be omitted, and even when the display apparatus is a portable appliance, the battery 1008 may be provided at a different position.

The display apparatus of the present embodiment may include red, green and blue color filters. The color filters may be arranged so that red, green and blue are arranged in a delta matrix.

The display apparatus of the present embodiment is used in a display unit of a portable terminal. Such a display apparatus may have both a display function and an operation function. Examples of the portable terminal include mobile phones such as smart phones, tablets, and head-mount displays.

The display apparatus of the present embodiment is used in a display unit of an imaging apparatus that includes an optical unit having multiple lenses, and an imaging element that receives light that has passed through the optical unit. The imaging apparatus may include a display unit that displays the information acquired by the imaging element. The display unit may be exposed to the outside of the imaging apparatus or may be disposed in a finder. The imaging apparatus may be a digital camera or a digital camcorder.

Fig. 4A is a schematic diagram illustrating one example of an imaging apparatus according to the present disclosure. An imaging apparatus 1100 includes a view finder 1101, a rear display 1102, an operation unit 1103, and a casing 1104. The view finder 1101 includes the display apparatus according to the present embodiment. In such a case, the display apparatus may display not only the image to be captured but also the environment information, imaging instructions, etc. The environment information may include the intensity of external light, the direction of the external light, the speed in which a photographic subject moves, and a possibility of the photographic subject becoming shielded by a shielding member.

Since the timing for imaging is very short, the information may be displayed as quickly as possible. Accordingly, a display apparatus that uses the organic light emitting element of the present disclosure can be used. This is because the organic light emitting element has a high response speed. A display apparatus that uses an organic light emitting element is preferred over a liquid crystal display apparatus for the use in such devices required to achieve speedy display.

The imaging device 1100 includes an optical unit not illustrated in the drawing. The optical unit has multiple lenses, and an image is focused on the imaging element contained in the casing 1104. The multiple lenses can adjust the focal point by adjusting the relative positions thereof. This operation can be automated. The imaging apparatus may also be referred to as a photoelectric conversion apparatus. The photoelectric conversion apparatus can employ an imaging method that involves a method for detecting the difference from a previous image, a method for always cutting out an image from a recorded image, or the like instead of sequential imaging.

Fig. 4B is a schematic diagram illustrating one example of electronic equipment according to the present disclosure. Electronic equipment 1200 includes a display unit 1201, an operation unit 1202, and a casing 1203. The casing 1203 may include a circuit, a print substrate having the circuit, a battery, and a communication unit. The operation unit 1202 may be a button or a touch panel-system sensitive unit. The operation unit may be a biometric unit that performs, for example, unlocking through fingerprint recognition. The electronic equipment that includes the communication unit can also be called communication equipment. The electronic equipment may further have a camera function when equipped with a lens and an imaging element. The image captured through the camera function is displayed on the display unit. Examples of the electronic equipment include smart phones and laptop computers.

Figs. 5A and 5B are schematic diagrams illustrating some examples of the display apparatus according to the present disclosure. Fig. 5A illustrates a display apparatus such as a television monitor or a PC monitor. A display apparatus 1300 includes a frame 1301 and a display unit 1302. The light emitting apparatus of the present disclosure is be used in the display unit 1302. The display apparatus 1300 further includes a base 1303 that supports the frame 1301 and the display unit 1302. The base 1303 is not limited to the type illustrated in Fig. 5A. The lower edge of the frame 1301 may also serve as the base. The frame 1301 and the display unit 1302 may be curved. The radius of curvature thereof may be 5000 mm or more and 6000 mm or less.

Figs. 5B is a schematic diagram illustrating another example of the display apparatus according to the present disclosure. A display apparatus 1310 illustrated in Fig. 5B is bendable, in other words, a foldable display apparatus. The display apparatus 1310 includes a first display unit 1311, a second display unit 1312, a casing 1313, and an inflection point 1314. The first display unit 1311 and the second display unit 1312 each include a light emitting apparatus of the present disclosure. The first display unit 1311 and the second display unit 1312 may constitute one seamless display apparatus. The first display unit 1311 and the second display unit 1312 can be separated at the inflection point. The first display unit 1311 and the second display unit 1312 may display different images, or may together display one image.

Fig. 6A is a schematic diagram illustrating one example of a lighting apparatus according to the present disclosure. A lighting apparatus 1400 includes a casing 1401, a light source 1402, a circuit substrate 1403, an optical filter 1404, and a light diffusing unit 1405. The light source 1402 includes an organic light emitting element of the present disclosure. The optical filter 1404 may be a filter that improves the color rendering properties of the light source. The light diffusing unit 1405 can effectively diffuse light from the light source 1402, such as for lighting up, and can deliver the light to a wide range. The optical filter 1404 and the light diffusing unit 1405 may be disposed on the light emitting side of the lighting. If necessary, a cover may be provided on the outermost side.

The lighting apparatus is, for example, an apparatus that illuminates the room. The lighting apparatus may emit light that is white, neutral white, or any color from blue to red. The lighting apparatus may also include a light modulating circuit that modulates these types of light. The lighting apparatus includes an organic light emitting element of the present disclosure and a power supply circuit connected to the organic light emitting element. The power supply circuit is a circuit

that converts AC voltage into DC voltage. White is a color that has a color temperature of 4200 K and the neutral white is a color that has a color temperature of 5000 K. The lighting apparatus may include a color filter.

The lighting apparatus of the present disclosure may include a heat releasing unit. The heat releasing unit is a unit that releases the heat inside the apparatus to the outside of the apparatus, and examples thereof include metals having a high specific heat, and liquid silicone.

Fig. 6B is a schematic diagram of an automobile which is one example of a moving body according to the present disclosure. The automobile includes a tail lamp, which is one example of a lighting unit. An automobile 1500 includes a tail lamp 1501 and may turn on the tail lamp upon braking operation or the like.

The tail lamp 1501 includes an organic light emitting element of the present disclosure. The tail lamp may also include a protection member that protects the organic light emitting element. The protection member may be composed of any material that has a sufficiently high strength and is transparent, and can be composed of polycarbonate or the like. The polycarbonate may be mixed with a furandicarboxylic acid derivative, an acrylonitrile derivative, or the like.

The automobile 1500 may include a car body 1503 and a window 1502 attached to the car body 1503. The window may be a transparent display if not a window for checking the front and rear sides of the automobile. This transparent display may include an organic light emitting element according to the present disclosure. In such a case, the materials constituting the electrodes, etc., of the organic light emitting element are transparent.

The moving body according to the present disclosure may be a ship, an airplane, a drone, or the like. The moving body includes a body and a lighting unit attached to the body. The lighting unit emits light to indicate the position of the body. The light unit includes an organic light emitting element of the present disclosure.

Referring now to Figs. 7A and 7B, examples of applications of the display apparatuses of the aforementioned embodiments are described. The display apparatus can be applied to wearable device systems such as smart glasses, HMD, and smart contact lenses. An imaging display apparatus used in such application examples includes an imaging apparatus capable of converting visible light into electricity, and a display apparatus capable of emitting visible light.

Fig. 7A illustrates glasses 1600 (smart glasses) according to one application example. An imaging apparatus 1602 such as a CMOS sensor or SPAD is disposed on a front side of a lens 1601 of the glasses 1600. The display apparatus according to any of the embodiments described above is disposed on a rear side of the lens 1601.

The glasses 1600 further include a controller 1603. The controller 1603 functions as a power supply that supplies power to the imaging apparatus 1602 and the display apparatus of the embodiment. The controller 1603 also controls the operation of the imaging apparatus 1602 and the display apparatus. An optical system for focusing light onto the imaging apparatus 1602 is formed in the lens 1601.

Fig. 7B illustrates glasses 1610 (smart glasses) according to one application example. The glasses 1610 include a controller 1612, and the controller 1612 includes an imaging apparatus that corresponds to the imaging apparatus 1602 illustrated in Fig. 7A, and a display apparatus. In a lens 1611, an optical system for projecting light emitted from the display apparatus and the imaging apparatus in the controller 1612 is formed, and images are projected onto the lens 1611. The controller 1612 functions as a power supply that supplies power to the imaging apparatus and the display apparatus, and also controls the operation of the imaging apparatus and the display apparatus. The controller 1612 may include a line-of-sight detecting unit that detects the line of sight of a wearer. The line of sight may be detected by using infrared radiation. The infrared radiation emitting unit emits infrared radiation toward an eyeball of a user gazing the displayed image. A captured image of the eyeball is obtained when the imaging unit having a light receiving element detects reflection of the emitted infrared radiation from the eyeball. The degradation of the image quality is decreased by providing a unit for reducing light from the infrared radiation emitting unit to the display unit in a plan view.

The line of sight of the user with respect to the displayed image is detected from the captured image of the eyeball obtained by infrared imaging. Any known technique can be applied to the line-of-sight detection using the captured image of the eyeball. For example, a line-of-sight detection method based on a Purkinje image formed by reflection of the irradiated light at the cornea can be employed. More specifically, a line-of-sight detection process based on the pupil-corneal reflection method is performed. The line of sight of the user is detected by calculating the eye vector that indicates the direction (rotation angle) of the eyeball on the basis of the image of the pupil and the Purkinje image included in the captured image of the eyeball by using the pupil-corneal reflection method.

The display apparatus of the present disclosure may include an imaging apparatus that includes a light receiving element, and may control the image displayed on the display apparatus on the basis of the line-of-sight information of the user from the imaging apparatus. Specifically, in the display apparatus, a first view region that the user gazes and a second view region other than the first view region are determined on the basis of the line-of-sight information. The first view region and the second view region may be determined by the controller in the display apparatus, or may be determined by an external controller and received. In the display region of the display apparatus, the display resolution of the first view region may be controlled to be higher than the display resolution of the second view region. In other words, the resolution of the second view region may be lower than that of the first view region.

The display region has a first display region and a second display region different from the first display region, and a region having a higher priority is determined from the first display region and the second display region on the

basis of the line-of-sight information. The first display region and the second display region may be determined by the controller in the display apparatus, or may be determined by an external controller and received. The resolution of the region with higher priority may be controlled to be higher than the resolution of the region other than the region with higher priority. In other words, the resolution of a region having relatively low priority may be decreased.

An AI may be used to determine the first view region or the region with high priority. The AI may be a model configurated to estimate the angle of the line of sight and the distance to the object at the end of the line of sight from the image of the eyeball by using, as teaching data, the image of the eyeball and the direction in which the eyeball in the image was actually gazing. The AI program may be included in the display apparatus, the imaging apparatus, or an external apparatus. When an external apparatus includes the AI program, the data is transmitted to the display apparatus via communication.

When the display is controlled on the basis of the visual recognition, smart glasses that further include an imaging apparatus that captures the images of the outside can be implemented. The smart glasses can display the captured outside information in real time.

Fig. 8A is a schematic diagram illustrating one example of an image forming apparatus according to one embodiment of the present disclosure. An image forming apparatus 1700 is an electrophotographic image forming apparatus and includes a photosensitive drum 1707, an exposure light source 1708, a charging unit 1710, a developing unit 1711, a transferring device 1712, a conveying roller 1713, and a fixing device 1715. Light 1709 is emitted from the exposure light source 1708, and an electrostatic latent image is formed on a surface of the photosensitive drum 1707. The exposure light source 1708 includes the organic light emitting element of the present disclosure. The developing unit 1711 includes a toner etc. The charging unit 1710 charges the photosensitive drum 1707. The transferring device 1712 transfers a developed image onto a recording medium 1714. The conveying roller 1713 conveys the recording medium 1714. The recording medium 1714 is, for example, a sheet of paper. The fixing device 1715 fixes the image formed on the recording medium 1714.

Figs. 8B and 8C are schematic diagrams illustrating the exposure light source 1708 in which light emitting units 1726 are arranged on a long substrate. The arrow 1727 indicates the direction parallel to the axis of the photosensitive body as well as the direction in which rows of the organic light emitting elements are arranged. This row direction is coincident with the axis of rotation of the photosensitive drum 1707. This direction can also be referred to as the longitudinal axis direction of the photosensitive drum 1707. Fig. 8B is an arrangement in which the light emitting units 1726 are arranged along the longitudinal axis direction of the photosensitive drum 1707. Fig. 8C illustrates an arrangement different from the one illustrated in Fig. 8B, in which the light emitting units 1726 in the first row and the second row are staggered. The first row and the second row are at different positions in the column direction. The first row includes multiple light emitting units 1726 with spaces therebetween. The second row includes light emitting units 1726 at positions corresponding to the spaces between the light emitting units 1726 in the first row. In other words, multiple light emitting units 1726 are arranged to be spaced from each other in the column direction also. The arrangement illustrated in Fig. 8C can also be referred to as a grid arrangement state, a houndstooth pattern, or a checkered pattern.

Fig. 9 is a schematic diagram illustrating one form of a light emitting device related to the present embodiment. The light emitting device of this embodiment can be used as, for example, a light source of an electrophotographic image forming apparatus. The light emitting device of this embodiment has a rectangular shape with long sides parallel to a first direction and short sides parallel to a direction intersecting the first direction, and the first direction may be, for example, a direction extending along the rotation axis direction of a photosensitive body of an image forming apparatus.

A substrate 1801 has a polygonal shape, and, here, an example in which the substrate 1801 has a rectangular shape is described. In this description, the long side direction of the rectangular substrate 1801 is referred to as the first direction, and the short side direction orthogonal to the long side direction is referred to as the second direction. For the purposes of this description, a polygonal shape includes a shape having rounded corners. A moisture proof ring 1800 that reduces penetration of moisture into the light emitting device is disposed on the rectangular substrate 1801. The moisture proof ring 1800 can be a guard ring constituted by a wiring layer.

A light emitting region 1802, a contact region 1803, a pad 1804, and a circuit 1806 are disposed within the moisture proof ring 1800. In this embodiment, the contact region 1803 includes a first contact region 1803_1, a second contact region 1803_2, and a third contact region 1803_3. The pad 1804 includes a first pad 1804_1, a second pad 1804_2, and a third pad 1804_3.

The circuit 1806 is one of the circuits that drive light emitting devices. Specific examples thereof include, but are not limited to, an input protection circuit, an input circuit through which data for driving is input, and a logic circuit for data processing.

In the light emitting region 1802, light emitting elements EL are lined up in a matrix. The contact region 1803 is a region where lines that electrically connect to a common electrode of the light emitting elements EL are disposed. The pad 1804_1 electrically connects the contact region 1803 to an external element.

The contour of the moisture proof ring 1800 may include multiple recessed portions. These portions can be used, for example, as contact regions where ribs of a mask for a vapor deposition step come into contact in the film

forming step.

Each of the multiple light emitting elements EL arranged in a matrix in the light emitting region 1802 includes, as described above, a light emission layer and a first electrode and a second electrode that sandwich the light emission layer. In this embodiment, an example in which the first electrode is an independent electrode provided for each of the light emitting elements EL and the second electrode is a common electrode shared by the light emitting elements EL is described.

For example, when four rows of light emitting elements EL are disposed in the light emitting region 1802, as illustrated in Fig. 9, the starting position of the second row of the light emitting elements EL may be shifted in the X direction from the starting position of the first row of the light emitting elements EL by a quarter of the dimension of the light emitting element EL in the X direction. When n is an integer of 2 or more and n rows are formed, the starting position of the second row of the light emitting elements EL may be shifted in the X direction from the starting position of the first row of the light emitting elements EL by 1/n of the dimension of the light emitting element EL in the X direction. This structure is advantageous in improving the resolution.

The contact region 1803 is an adjacent region to the light emitting region 1802 of the substrate 1801 and is disposed within the moisture proof ring 1800. Furthermore, at least one of the first contact region 1803, the pad 1804, and the circuit region 1806 may be disposed, together with the recessed portions of the moisture proof ring 1800, between the light emitting region 1802 and one of the long side edges of the substrate 1801 in a straight line with respect to the long side direction.

As such, when the contact region 1803, the pad 1804, the circuit region 1806, etc., are disposed at the same position in the short side direction, the length of the light emitting device in the short side direction can be decreased, and the light emitting device can be miniaturized.

The light emitting device of this embodiment has, along the long side edge of the light emitting device, multiple contact regions 1803 where the common electrode for the light emitting elements EL contacts the power supply line. When the common electrode is composed of a transparent electrode material having a relatively high electrical resistance, the voltage drop may increase in the longitudinal axis direction. As a result, depending on the distance from the contact region where the potential is supplied, the voltage applied to each OLED varies. Thus, the OLEDs to which a voltage for causing light emission of the same luminance is applied may actually emit light with different luminances, and thus shading or the like would occur. As in this embodiment, when multiple contact regions 1803 are arranged in the longitudinal direction, the voltage drop at the common electrode in the long side direction can be reduced, and occurrence of shading or the like can be reduced.

In this embodiment, an example in which the light emitting device is used in a head substrate 1900 of an exposure head of an image forming apparatus is described with reference to Figs. 10A to 10C.

Fig. 10A is a schematic perspective view of the head substrate 1900. Fig. 10B illustrates the arrangement of multiple light emitting elements EL in the head substrate 1900, and Fig. 10C is an enlarged view of one portion of Fig. 10B.

LED chips 1903 are mounted onto the head substrate 1900. For example, the light-emitting device illustrated in Figs. 8A to 8C can be used as the LED chips 1903.

As illustrated in Fig. 10A, LED chips 1903 are disposed on one surface of the head substrate 1900, and a long flexible flat cable (FFC) connector 1907 is disposed on the other surface of the head substrate 1900. Here, the one surface of the head substrate 1900 is a surface (upper surface or surface) on which the LED chips 1903 are disposed. The other surface of the substrate is the surface (lower surface or rear surface) opposite of the surface on which the LED chips 1903 are disposed.

The FFC connector 1907 is attached to the other surface (lower surface or rear surface) of the head substrate 1900 so that the longitudinal direction thereof extends in the longitudinal direction of the head substrate 1900. The long FFC connector 1907 is provided to input control signals (driving signals) from a control circuit unit of the main body of the image forming apparatus, and the control signals are transferred to the LED chips 1903. The LED chips 1903 are driven (operation of turning light ON and OFF) by control signals input to the head substrate 1900.

The LED chips 1903 mounted on the head substrate 1900 will now be described. As illustrated in Figs. 10B and 10C, multiple light emitting elements EL are disposed on one surface of the head substrate 1900. For example, LED chips 1903-1 to 1903-29 (29 chips) are provided. In Fig. 10B, the LED chips 1903_1, 1903_13, 1903_14, 1903_15, 1903_16, and 1903_29 are illustrated as examples. In each of the LED chips 1903-1 to 1903-29, multiple light emitting elements EL are arranged in its longitudinal direction, and, for example, 516 light emitting elements EL are provided.

In the longitudinal direction of the LED chips 1903, the center-to-center distance k2 between the adjacent light emitting elements EL corresponds to the resolution of the image forming apparatus. For example, when the resolution of the image forming apparatus of this embodiment is 1200 dpi, the light emitting elements EL are arranged so that the center-to-center distance k2 between the adjacent light emitting elements EL is 21.16 μm in the longitudinal direction of the LED chips 1903-1 to 1903-29. Thus, the exposure range of the exposure head of this embodiment is about 314 mm.

The photosensitive layer of the photosensitive drum has a width of 314 mm or more. Since the length of the long side of an A4-size recording sheet and the length of the short side of an A3-size recording sheet are 297 mm, the

exposure head of this embodiment has an exposure range with which images can be formed on A4-size recording sheets and A3-size recording sheets. Here, although an example in which multiple light emitting elements EL are arranged in the longitudinal direction is illustrated in Fig. 10B, light emitting elements EL may be arranged in the transverse direction as well as in the longitudinal direction.

LED chips 1903-1 to 1903-29 are arranged in the axis direction of the photosensitive drum. Specifically, the LED chips 1903-1 to 1903-29 are arranged in two staggered rows along the axis direction of the photosensitive drum. In other words, as illustrated in Fig. 10B, when counted from the left, the odd-numbered LED chips 1903-1, 1903-3, ..., and 1903-29 are mounted in one row in the longitudinal direction of the substrate 1900. When counted from the left, the even-numbered LED chips 1903-2, 1903-4, ..., and 1903-28 are mounted in one row in the longitudinal direction of the substrate 1900. The LED chips 1903 are arranged in such a manner.

As a result, as illustrated in Fig. 10C, in the longitudinal direction of the LED chips 1903, the center-to-center distance k1 of the light emitting elements EL and the center-to-center distance k2 of the light emitting elements EL can be equal to each other. Here, the center-to-center distance k1 of the light emitting elements EL is the center-to-center distance between the light emitting element EL at one end of the LED chip 1903_13 and the light emitting element EL at one end of the LED chip 1903_14. The center-to-center distance k2 of the light emitting elements EL is the center-to-center distance between the light emitting elements EL that are adjacent to each other in the LED chip 1903_14.

In other words, the center-to-center distance k1 between the light emitting element EL at one end of one LED chip 1903 and the light emitting element EL at one end of another LED chip 1903 that are adjacent to each other can be made equal to the center-to-center distance k2 of the adjacent light emitting elements EL in the same LED chip 1903.

Here, in this embodiment, the light emitting elements EL are organic light emitting elements of a current-driven type. The organic light emitting elements are, for example, arranged on a line along the main scanning direction (the axis direction of the photosensitive drum 1707) on a thin film transistor (TFT) substrate, and are electrically connected in parallel through a power supply line formed along the main scanning direction.

It should be noted that when the light emitting device is used in an exposure head, linear light is used for exposure and thus the longitudinal direction -to-transverse direction ratio of the shape of the light emitting region 1802 is larger than when the light emitting device is used in a display apparatus or the like. In addition, the shape of the substrate for the LED chips also has a large longitudinal direction -to-transverse direction ratio.

Specifically, for example, the length of the long side of the LED chip (or the light emitting region 1802) can be at least five times or at least 10 times larger than the length of the short side of the LED chip (or the light emitting region 1802). For example, the length of the long side of the LED chip (or the light emitting region 1802) can be at least twenty times larger than the length of the short side of the LED (or the light emitting region 1802).

The length of the long side of the LED chips is determined by the length of the photosensitive drum 1707 in the axis direction, the number of LED chips arranged in the axis direction, and the pattern in which the LED chips 1903 are arranged. Furthermore, the length of the short side of the LED chip 1903 is determined by whether the light emitting elements EL are disposed in the light emitting region 1802 in a direction perpendicular to the axis of the photosensitive drum 1707 or by the arrangement of the pad 1804 and the contact region 1803.

Furthermore, the light emitting unit 1726 may include a light emission layer that emits red light in view of dependency of the photosensitivity of the photosensitive drum 1707 on the wavelength.

The LED chips 1803 may include color filters. The color filters can absorb stray light from unintended directions without reducing the amount of regular light incident on the photosensitive drum, and thus the printing quality can be improved.

As described heretofore, by using apparatuses that use the organic light emitting element of the present disclosure, a display with excellent image quality and stable for a long period of time can be achieved.

Features that are included

The disclosure of the present embodiments includes the following features.

Feature 1

An organic light emitting element including: an anode; a cathode; a light emission layer that is disposed between the anode and the cathode, contains a host material and a light emitting dopant material, and has an anode side facing the anode and a cathode side facing the cathode; a first organic compound layer in contact with the anode side of the light emission layer; and a second organic compound layer in contact with the cathode side of the light emission layer, wherein formulae (1), (2-1), and (2-2) are satisfied:

$$\mu 1H \geq \mu 2E \qquad (1)$$

$$HOMOh < HOMOd \qquad (2\text{-}1)$$

$$LUMOh > LUMOd \qquad (2\text{-}2)$$

$\mu 1H$ is a hole mobility of the first organic compound layer,
$\mu 2E$ is an electron mobility of the second organic compound layer,
HOMOh is a highest occupied molecular orbital (HOMO) level of the host material,
LUMOh is a lowest unoccupied molecular orbital (LUMO) level of the host material,
HOMOd is a HOMO level of the light emitting dopant material,
LUMOd is a LUMO level of the light emitting dopant material.

Feature 2

The organic light emitting element of feature 1, wherein the host material and the light emitting dopant material satisfy formulae (3-1) and (3-2):

$$HOMOd - HOMOh \geq 0.15\ eV \qquad (3\text{-}1)$$

$$LUMOh - LUMOd \geq 0.15\ eV \qquad (3\text{-}2).$$

Feature 3

The organic light emitting element of feature 1 or 2, wherein the host material and the light emitting dopant material are each a hydrocarbon.

Feature 4

The organic light emitting element of any one of features 1 to 3, wherein the host material has a perylene skeleton.

Feature 5

The organic light emitting element of any one of features 1 to 4, wherein emission color is red.

Feature 6

The organic light emitting element of any one of features 1 to 5, wherein a material that constitutes the second organic compound layer is a hydrocarbon. Feature 7
The organic light emitting element of feature 6, wherein the second organic compound layer has an electron mobility $\mu 2E$ of $1 \times 10^{-3}$ $cm^2/Vs$ or less.

Feature 8

The organic light emitting element of feature 7, wherein a material that constitutes the second organic compound layer has a fluoranthene skeleton or a pyrene skeleton.

Feature 9

A display apparatus including a plurality of pixels, wherein at least one of the plurality of pixels includes the organic light emitting element of any one of features 1 to 8 and a transistor connected to the organic light emitting element.

Feature 10

A photoelectric conversion apparatus including: an optical unit that includes a plurality of lenses; an imaging element that receives light that has passed through the optical unit; and a display unit that displays an image taken by

the imaging element,
wherein the display unit includes the organic light emitting element of any one of features 1 to 8.

Feature 11

Electronic equipment including: a display unit that includes the organic light emitting element of any one of features 1 to 8; a casing in which the display unit is installed; and a communication unit that is installed in the casing and communicates with outside.

Feature 12

A lighting apparatus including: a light source that includes the organic light emitting element of any one of features 1 to 8; and a light diffusing unit or an optical filter that transmits light emitted from the light source.

Feature 13

A moving body including: a lighting unit that includes the organic light emitting element of any one of features 1 to 8; and a body that includes the lighting unit. Feature 14
An image forming apparatus including: a photosensitive body; and an exposure light source that exposes the photosensitive body to light, wherein the exposure light source includes the organic light emitting element of any one of features 1 to 8.

EXAMPLES

Measurement of HOMO/LUMO levels

The energy E(eV) of a bandgap (hereinafter referred to as "B.G.") was calculated from the measurement of the HOMO levels of the host materials and the light emitting dopant materials in the light emission layers used in Examples and Comparative Examples and measurement of the wavelengths λ (nm) of the absorption edge of an absorption spectrum. The absorption spectrum peak wavelength λ (nm) is converted into the B.G. energy value E(eV) by formula (4) below:

$$E(eV) = hc/e\lambda \times 10^9 \quad (4)$$

(Here, h represents a Planck's constant, c represents the speed of light, and e represents the elementary charge.)
The LUMO level is calculated from the HOMO level and the B.G. energy value through formula (5) below:

$$\text{LUMO (eV)} = \text{HOMO (eV)} + \text{B.G. (eV)} \quad (5)$$

Here, the HOMO level was measured by using an atmospheric photoelectron spectrometer (trade name: AC-3 produced by RIKEN KEIKI CO., LTD.). The results are indicated in Table 1.

Table 1

| | Compound | HOMO (eV) | B.G. (eV) | LUMO (eV) |
|---|---|---|---|---|
| Host material | H1 | -5.77 | 2.54 | -3.23 |
| | H3 | -5.76 | 2.46 | -3.30 |
| | H4 | -5.77 | 2.50 | -3.27 |
| | H10 | -5.63 | 2.42 | -3.21 |
| | AD-2 | -5.97 | 2.92 | -3.05 |
| | AD-14 | -6.00 | 2.95 | -3.05 |
| | ET16 | -6.15 | 3.09 | -3.06 |

(continued)

| | Compound | HOMO (eV) | B.G. (eV) | LUMO (eV) |
|---|---|---|---|---|
| Light emitting dopant material | RD1 | -5.60 | 2.00 | -3.60 |
| | RD4 | -5.52 | 2.04 | -3.48 |
| | RD5 | -5.62 | 1.98 | -3.64 |
| | RD8 | -5.48 | 1.88 | -3.60 |
| | RD9 | -5.55 | 1.86 | -3.69 |
| | RD11 | -5.59 | 1.90 | -3.69 |
| | RD20 | -5.59 | 1.92 | -3.67 |
| | AD-21 | -6.45 | 2.82 | -3.63 |

Measurement of mobility

To measure the hole mobility μ1H ($cm^2/Vs$) of the first organic compound layer and the electron mobility μ2E ($cm^2/Vs$) of the second organic compound layer, mobility measurement elements were prepared by the following method.

On an ITO-attached glass substrate, a first organic compound layer or a second organic compound layer was formed into a film thickness of 2 μm by vapor deposition. Next, a 150 nm thick aluminum film was formed by a vacuum evaporation process. Lastly, to prevent element deterioration caused by adsorption of moisture onto the surface of the element on which the film was formed, a protection glass was overlaid thereon in a nitrogen atmosphere, and an UV adhesive was applied and cured. As a result, mobility measurement elements were obtained.

By performing transient current measurement by a time-of-flight (TOF) method on the obtained mobility measurement elements, the hole mobility μ1H of the first organic compound layer and the electron mobility μ2E of the second organic compound layer 6 could be measured. Specifically, a time-of-flight measurement instrument (TOF-301 produced by OPTEL Co., LTD.) was used to measure the hole mobility μ1H and the electron mobility μ2E at an electric field intensity of $5 \times 10^5$ V/cm. The results are indicated in Table 2.

Table 2

| | Compound | μ 1H ($cm^2/Vs$) | μ 2E ($cm^2/Vs$) |
|---|---|---|---|
| First organic compound layer | HT1 | $1.2\times10^{-3}$ | - |
| | HT2 | $1.8\times10^{-3}$ | - |
| | HT3 | $2.3\times10^{-3}$ | - |
| | HT6 | $2.5\times10^{-3}$ | - |
| | HT8 | $1.7\times10^{-3}$ | - |
| | HT14 | $5.1\times10^{-4}$ | - |
| Second organic compound layer | AD-1 | - | $4.0\times10^{-4}$ |
| | AD-2 | - | $6.0\times10^{-4}$ |
| | AD-7 | - | $4.5\times10^{-4}$ |
| | AD-9 | - | $1.0\times10^{-3}$ |
| | AD-15 | - | $9.0\times10^{-5}$ |
| | AD-19 | - | $5.0\times10^{-5}$ |
| | AD-23 | - | $1.2\times10^{-5}$ |
| | AD-25 | | $3.1\times10^{-3}$ |
| | ET7 | - | $5.3\times10^{-5}$ |

Example 1

In this Example, an organic light emitting element having a layer configuration illustrated in Fig. 1A was prepared by the following method.

A 40 nm-thick titanium (Ti) film was formed as an anode 2 on a silicon substrate by a sputtering method and was photolithographically patterned so as to form regular hexagonal-Ti pixel array and wiring with a pixel pitch of 4.2 μm. A silicon nitride (SiN) insulating layer was formed on Ti and was photolithographically patterned so as to form a pixel array exposing Ti while the width of the SiN insulating layer that partitioned the pixels was 1 μm.

Subsequently, the water-washed substrate with the layers up to the insulating layer formed thereon, and the materials placed in a molybdenum or tungsten vapor deposition boat were installed in a vacuum vapor deposition apparatus, and UV/ozone washing was performed. After evacuating to $1.0 \times 10^{-4}$ Pa ($1 \times 10^{-6}$ Torr), films were formed into a layer configuration indicated in Table 3 below, and the resulting substrate was transferred to a glove box and sealed with a desiccant-containing glass cap in a nitrogen atmosphere to obtain an organic light emitting element.

Table 3

| | Material | Film thickness (nm) |
|---|---|---|
| Cathode | Mg:Ag=50:50 (volume ratio) | 15 |
| Electron injection layer | LiF | 1 |
| Electron transport layer | ET2 | 35 |
| Second organic compound layer | AD-2 | 30 |
| Light emission layer | H4:RD9=99.8:0.2 (volume ratio) | 20 |
| First organic compound layer | HT1 | 40 |
| Hole injection layer | HT16 | 5 |

A voltage source was connected to the obtained organic light emitting element to evaluate the characteristics of the organic light emitting element. The voltage-current characteristic was measured with a pico ammeter 4140B produced by Hewlett-Packard Company, and the emission spectrum and the emission luminance were acquired by using SR-3 produced by TOPCON TECHNOHOUSE CORPORATION. The driving voltage used to emit light having a luminance of 3000 $cd/m^2$ was 3.2 V. This element was continuously driven in a dry air atmosphere while keeping the luminance at a current density of 1600 $mA/cm^2$, and the time (LT95) taken for the initial emission luminance to drop to 95% was as long as 400 hours. The organic light emitting element exhibited good durability lifetime and low voltage.

The obtained multilayer organic light emitting element satisfied the feature 1 of the present disclosure described above and the optional features 2 to 7 described above.

Examples 2 to 15 and Comparative Examples 1 to 3

Organic light emitting elements were prepared as in Example 1 except that the host material, the light emitting dopant material, and the materials for the first organic compound layer and the second organic compound layer of Example 1 were changed to the materials indicated in Table 4. AD-25 used in the second organic compound layer in Comparative Example 1 and HT14 used in the first organic compound layer in Comparative Example 2 are indicated below.

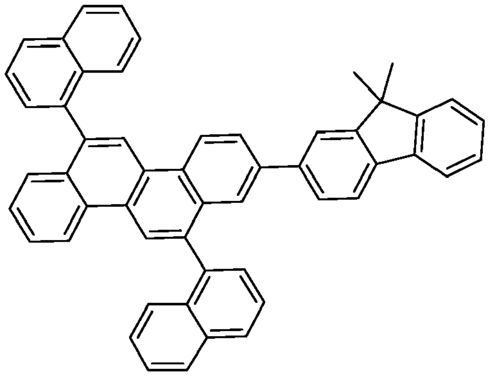

AD-25

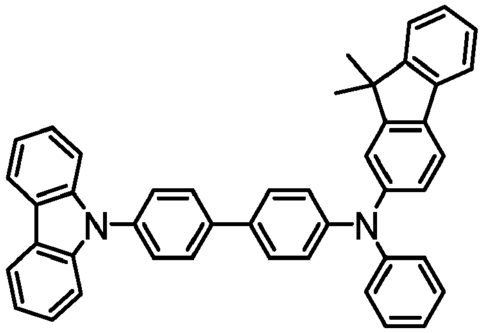

HT14

The properties of the obtained elements were measured and evaluated as in Example 1. The results of the measurement along with the results of Example 1 are indicated in Table 4.

Table 4

| | First organic compound layer | Light emission layer | | Second organic compound layer | Voltage (V) | LT95 (hr) |
|---|---|---|---|---|---|---|
| | | Host material | Light emitting dopant material | | | |
| Example 1 | HT1 | H4 | RD9 | AD-2 | 3.2 | 400 |
| Example 2 | HT2 | H1 | RD11 | AD-9 | 3.5 | 380 |
| Example 3 | TH3 | H3 | RD20 | AD-1 | 3.6 | 450 |
| Example 4 | HT6 | H10 | RD8 | AD-7 | 3.8 | 420 |
| Example 5 | HT2 | H4 | RD20 | AD-2 | 3.7 | 410 |
| Example 6 | HT3 | H1 | RD9 | AD-7 | 3.3 | 400 |
| Example 7 | HT1 | H3 | RD11 | AD-9 | 3.6 | 380 |
| Example 8 | HT8 | H4 | RD5 | AD-15 | 4.0 | 410 |
| Example 9 | HT3 | H3 | RD8 | AD-19 | 4.2 | 420 |
| Example 10 | HT1 | H1 | RD9 | AD-23 | 4.5 | 430 |
| Example 11 | HT3 | H4 | RD4 | AD-2 | 3.7 | 300 |
| Example 12 | HT2 | H3 | RD1 | AD-15 | 4.5 | 380 |
| Example 13 | HT1 | AD-2 | RD9 | AD-19 | 4.3 | 390 |

(continued)

| | First organic compound layer | Light emission layer | | Second organic compound layer | Voltage (V) | LT95 (hr) |
|---|---|---|---|---|---|---|
| | | Host material | Light emitting dopant material | | | |
| Example 14 | HT3 | H1 | RD8 | ET7 | 3.8 | 320 |
| Example 15 | HT2 | ET16 | RD20 | AD-1 | 4.7 | 300 |
| Comparative Example 1 | HT1 | H4 | RD9 | AD-17 | 3.3 | 250 |
| Comparative Example 2 | HT14 | H4 | RD9 | AD-2 | 5.5 | 200 |
| Comparative Example 3 | HT1 | AD-14 | AD-21 | AD-2 | 6.2 | 180 |

As indicated in Table 4, the organic light emitting elements of Examples that satisfy the feature 1 of the present disclosure has a low driving voltage and long durability lifetime. In particular, the organic light emitting elements of Examples 1 to 10 that have features 2 to 7 yielded good results.

The tendency of low voltage is approximately a reflection of the difference in HOMO level between the host material and the light emitting dopant material and the value of the electron mobility $\mu 2E$ of the second organic compound layer. Meanwhile, the LT95 durability lifetime is approximately a reflection of the difference between the hole mobility $\mu 1H$ of the first organic compound layer and the electron mobility $\mu 2E$ of the second organic compound layer, and organic light emitting elements having low voltage and good durability lifetime are obtained.

Compared to the elements of Examples, the element of Comparative Example 1 had poor durability lifetime. The reason for this is considered that because $\mu 1H < \mu 2E$ in Comparative Example 1, the exciton generating region shifted toward the amine bond-containing first organic compound layer, the light emission layer became unstable against radical cations generated by further recombination of the generated excitons and holes, and thus deterioration of the light emission layer was accelerated.

In the element of Comparative Example 2, the driving voltage was higher than the elements of Examples, and the durability lifetime was also poor. As in Comparative Example 1, the reason for this is considered that because $\mu 1H < \mu 2E$, the exciton generating region shifted toward the amine bond-containing first organic compound layer, the light emission layer became unstable against radical cations generated by further recombination of the generated excitons and holes, and thus deterioration of the light emission layer was accelerated. Furthermore, since HT14 has one less amine structure than HT1 and has a carbazole skeleton instead, the HOMO level was lower, and presumably thus the hole injection barrier from the anode side was raised and the voltage increased.

In the element of Comparative Example 3, the driving voltage was higher than the elements of Examples, and the durability lifetime was also poor. In the element of Comparative Example 3, the HOMO level of the host material AD-14 was higher than the HOMO level of the light emitting dopant material AD-21 and thus formula (2-1) was not satisfied. Thus, the hole injectability from the first organic compound layer to the light emission layer decreased notably, and thus the voltage increased. At the same time, since holes accumulate at the interface between the first organic compound layer and the light emission layer, the exciton generating region shifts toward the first organic compound layer, and the first organic compound layer becomes deteriorated. Presumably because of the high driving voltage and accelerated deterioration of the first organic compound layer, the durability lifetime of the element has decreased.

According to the present disclosure, an organic light emitting element that can be driven at low voltage and that exhibits excellent driving durability is provided. Thus, an excellent organic light emitting display apparatus that uses such organic light emitting elements can be provided.

While the present disclosure has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

An organic light emitting element that includes an anode (2), a cathode (9), a first organic compound layer (4), a light emission layer (5) containing a host material and a light emitting dopant material, and a second organic compound layer (6). The relationships concerning HOMO levels and LUMO levels of the host material and the light emitting dopant material in the light emission layer (5) are specified, and the materials for these layers are selected so that the hole mobility of the first organic compound layer (4) is equal to or greater than the electron mobility of the second organic compound layer (6).

## Claims

1. An organic light emitting element comprising:

   an anode (2);
   a cathode (9);
   a light emission layer (5) that is disposed between the anode and the cathode, contains a host material and a light emitting dopant material, and has an anode side facing the anode and a cathode side facing the cathode;
   a first organic compound layer (4) in contact with the anode side of the light emission layer; and
   a second organic compound layer (6) in contact with the cathode side of the light emission layer,
   wherein formulae (1), (2-1), and (2-2) are satisfied:

$$\mu 1H \geq \mu 2E \qquad (1)$$

$$HOMOh < HOMOd \qquad (2\text{-}1)$$

$$LUMOh > LUMOd \qquad (2\text{-}2)$$

   $\mu$1H is a hole mobility of the first organic compound layer,
   $\mu$2E is an electron mobility of the second organic compound layer,
   HOMOh is a highest occupied molecular orbital (HOMO) level of the host material,
   LUMOh is a lowest unoccupied molecular orbital (LUMO) level of the host material,
   HOMOd is a HOMO level of the light emitting dopant material,
   LUMOd is a LUMO level of the light emitting dopant material.

2. The organic light emitting element according to Claim 1, wherein the host material and the light emitting dopant material satisfy formulae (3-1) and (3-2):

$$HOMOd - HOMOh \geq 0.15\ eV \qquad (3\text{-}1)$$

$$LUMOh - LUMOd \geq 0.15\ eV \qquad (3\text{-}2).$$

3. The organic light emitting element according to Claim 1, wherein a material that constitutes the second organic compound layer is a hydrocarbon.

4. The organic light emitting element according to Claim 1, wherein the host material and the light emitting dopant material are each a hydrocarbon.

5. The organic light emitting element according to Claim 1, wherein the host material has a perylene skeleton.

6. The organic light emitting element according to Claim 1, wherein emission color is red.

7. The organic light emitting element according to Claim 1, wherein the second organic compound layer has an electron mobility $\mu$2E of $1 \times 10^{-3}$ $cm^2/Vs$ or less.

8. The organic light emitting element according to Claim 7, wherein a material that constitutes the second organic compound layer has a fluoranthene skeleton or a pyrene skeleton.

9. A display apparatus (1000, 1300, 1310) comprising:

   a plurality of pixels,
   wherein at least one of the plurality of pixels includes the organic light emitting element according to any one of Claims 1 to 8 and a transistor connected to the organic light emitting element.

**10.** A photoelectric conversion apparatus (1100) comprising:

an optical unit that includes a plurality of lenses;
an imaging element that receives light that has passed through the optical unit; and
a display unit that displays an image taken by the imaging element,
wherein the display unit includes the organic light emitting element according to any one of Claims 1 to 8.

**11.** Electronic equipment (1200) comprising:

a display unit (1201) that includes the organic light emitting element according to any one of Claims 1 to 8;
a casing (1203) in which the display unit is installed; and
a communication unit that is installed in the casing and communicates with outside.

**12.** A lighting apparatus (1400) comprising:

a light source (1402) that includes the organic light emitting element according to any one of Claims 1 to 8; and
a light diffusing unit (1405) or an optical filter (1404) that transmits light emitted from the light source (1402).

**13.** A moving body (1500) comprising:

a lighting unit (1501) that includes the organic light emitting element according to any one of Claims 1 to 8; and
a body that includes the lighting unit.

**14.** An image forming apparatus (1700) comprising:

a photosensitive body (1707); and
an exposure light source (1708) that exposes the photosensitive body (1707) to light,
wherein the exposure light source (1708) includes the organic light emitting element according to any one of Claims 1 to 8.

FIG. 1A

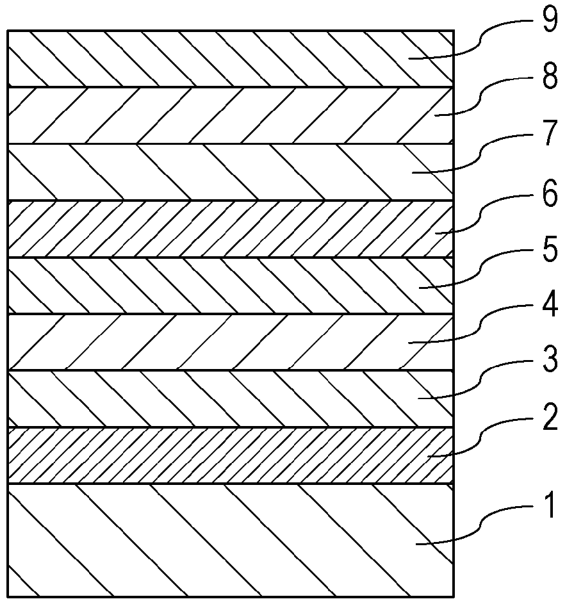
9
8
7
6
5
4
3
2
1

FIG. 1B

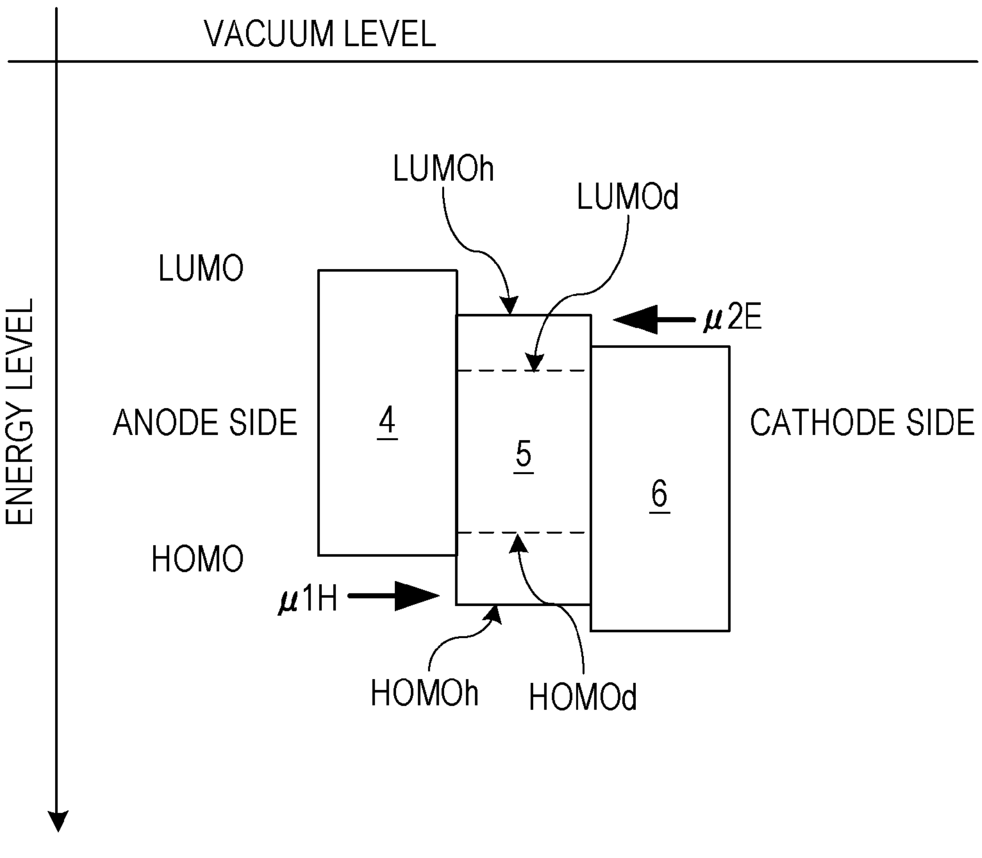
VACUUM LEVEL
ENERGY LEVEL
LUMOh
LUMOd
LUMO
μ2E
ANODE SIDE
4
5
6
CATHODE SIDE
HOMO
μ1H
HOMOh
HOMOd

FIG. 2A

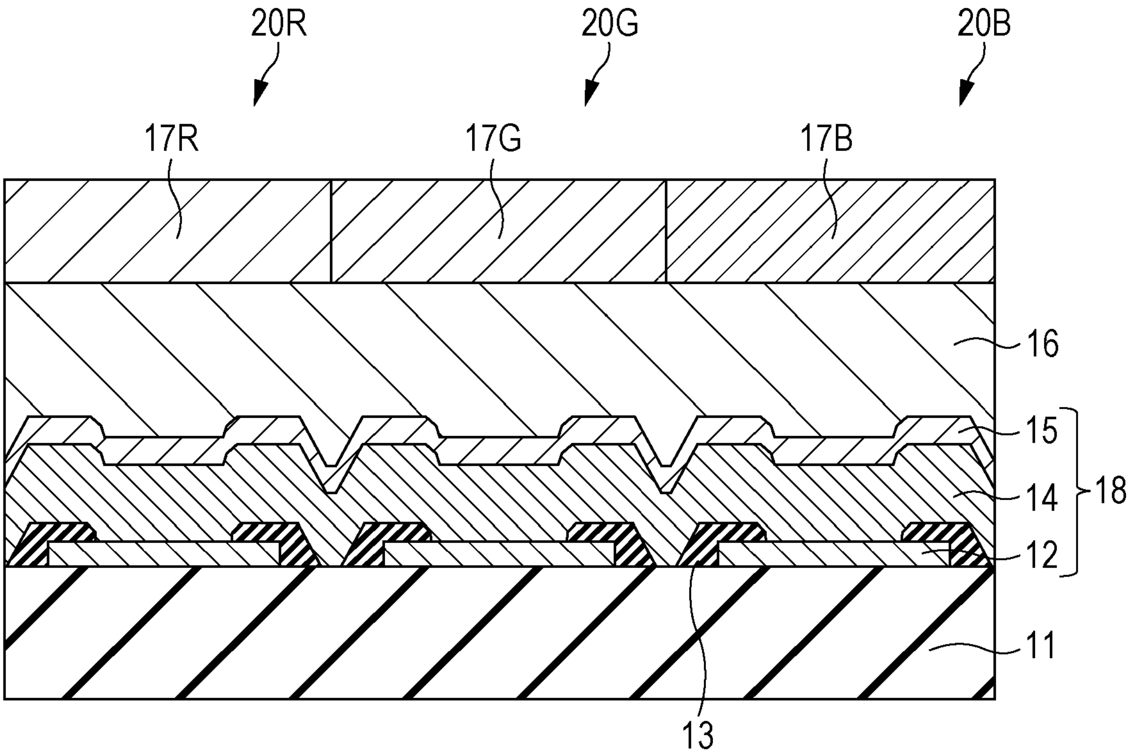

20R
20G
20B
17R
17G
17B
16
15
14
18
12
11
13


FIG. 2B

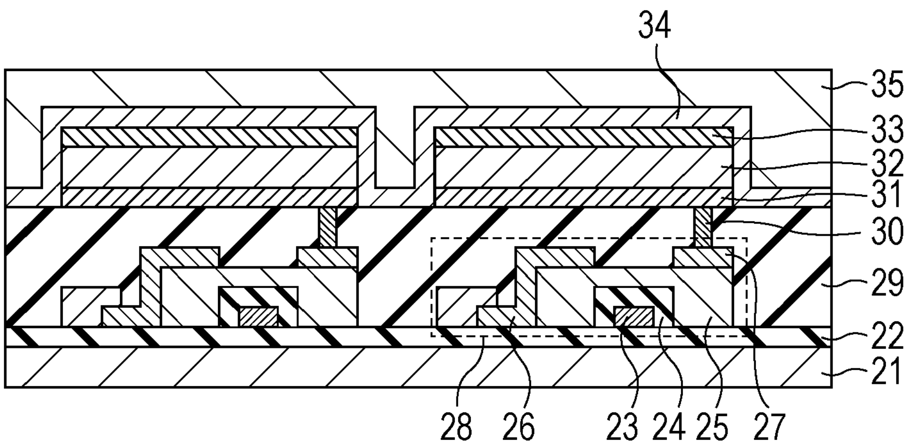

34
35
33
32
31
36
30
29
22
21
28
26
23
24
25
27

FIG. 3

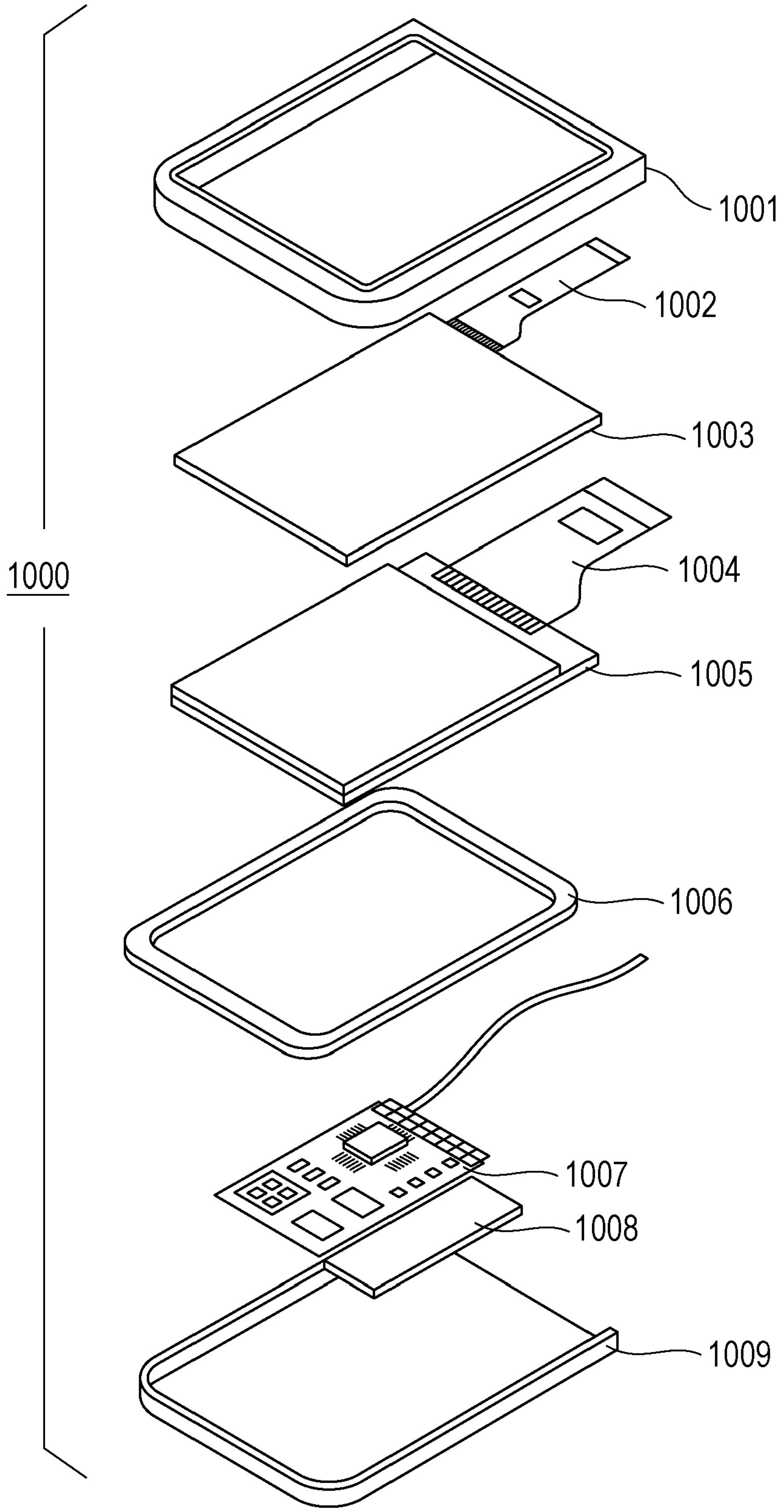

FIG. 4A

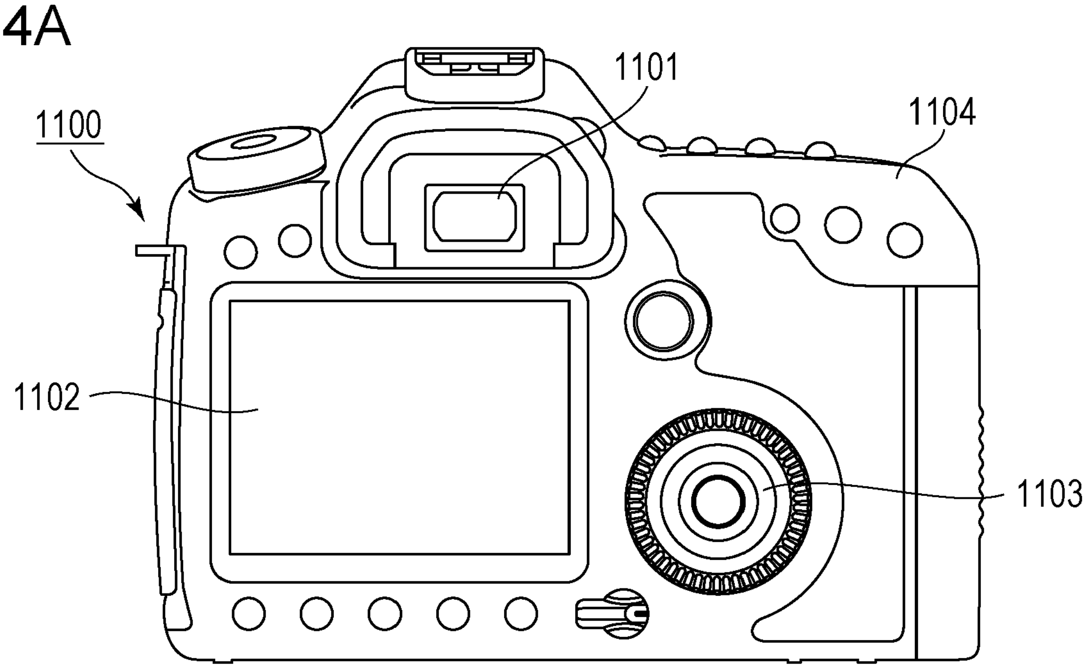


FIG. 4B

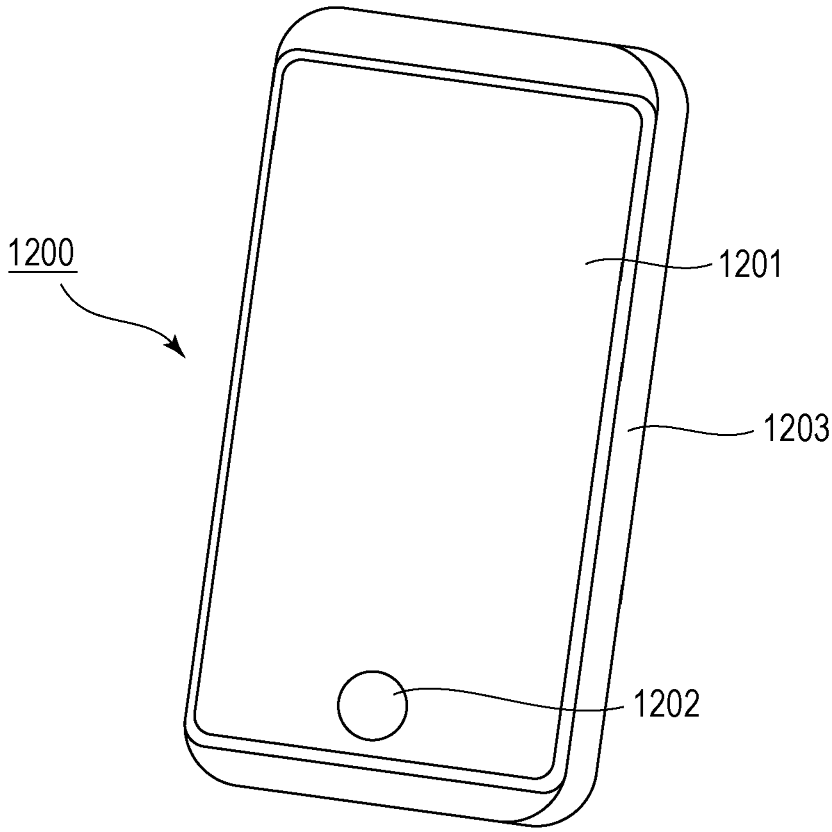

FIG. 5A

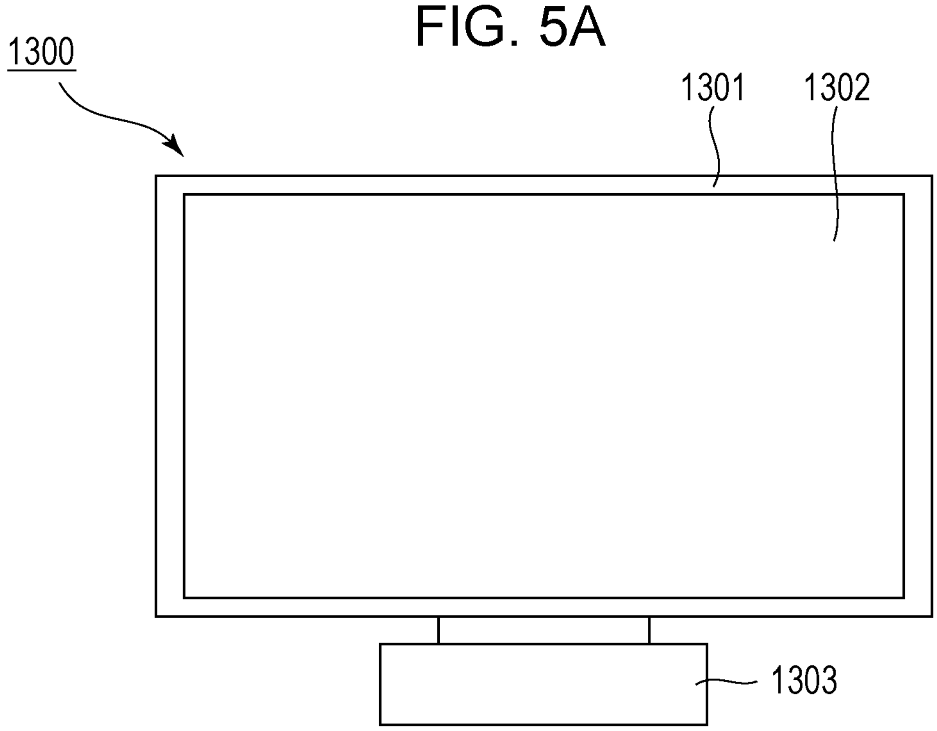


FIG. 5B

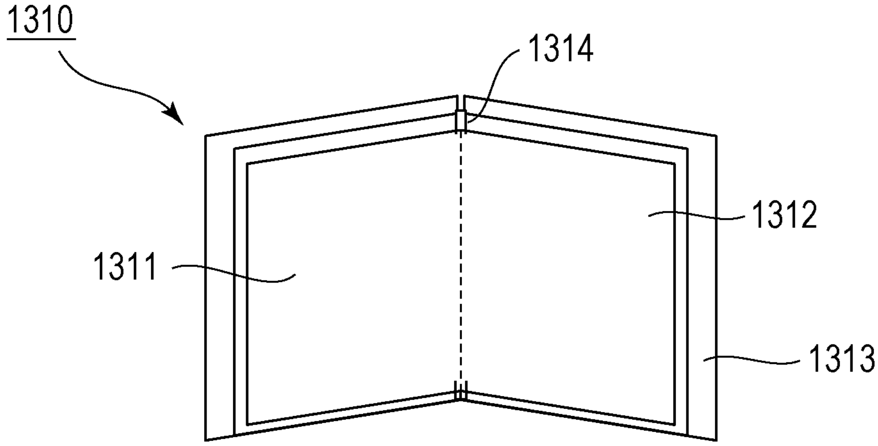

FIG. 6A

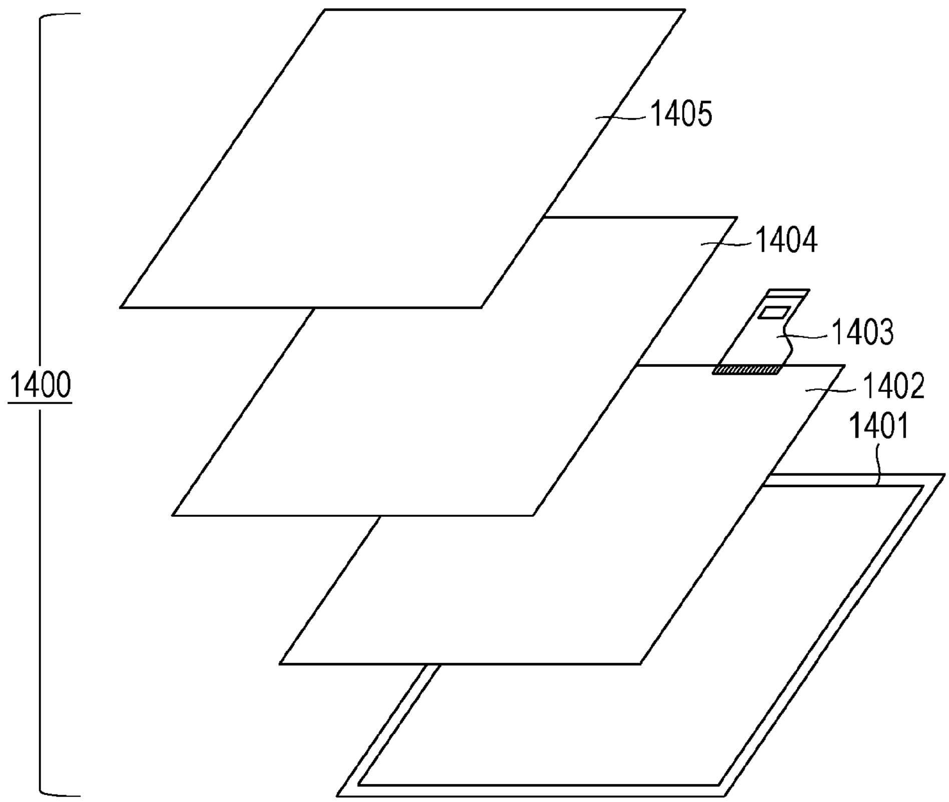


FIG. 6B

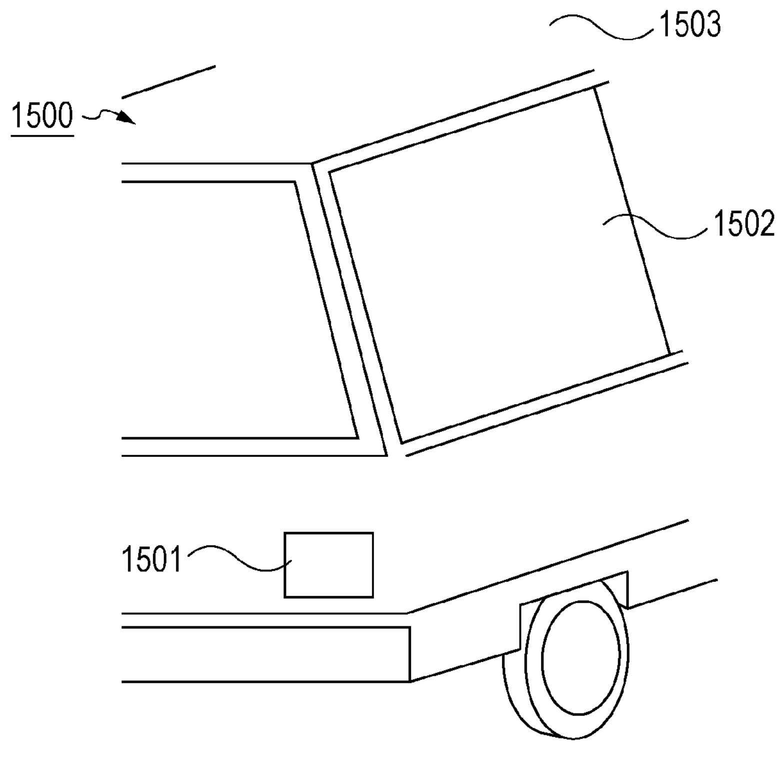

FIG. 7A

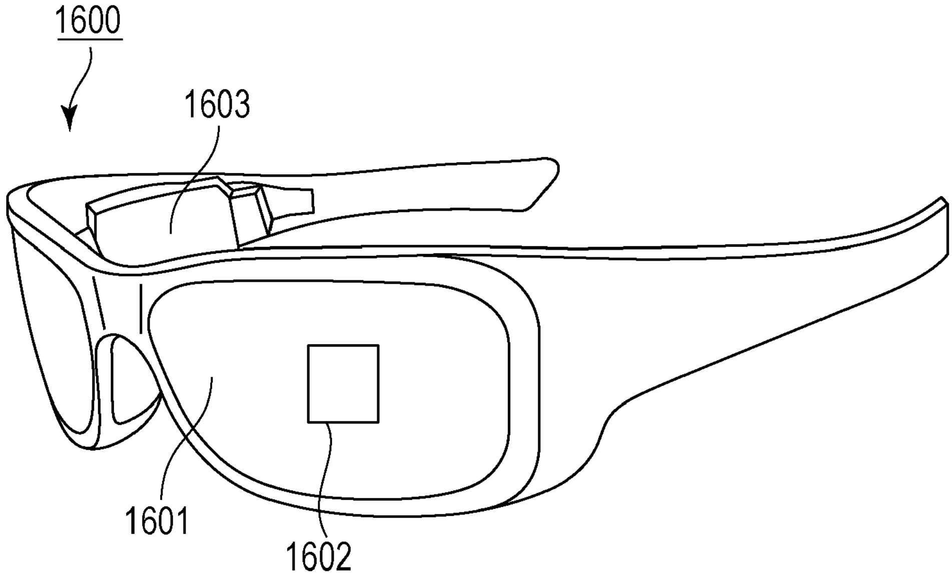


FIG. 7B

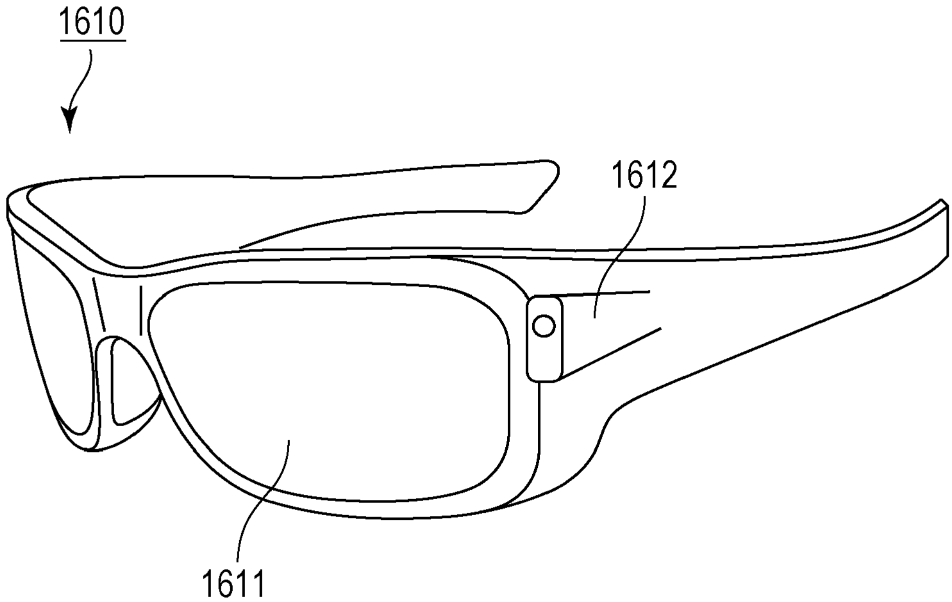

FIG. 8A

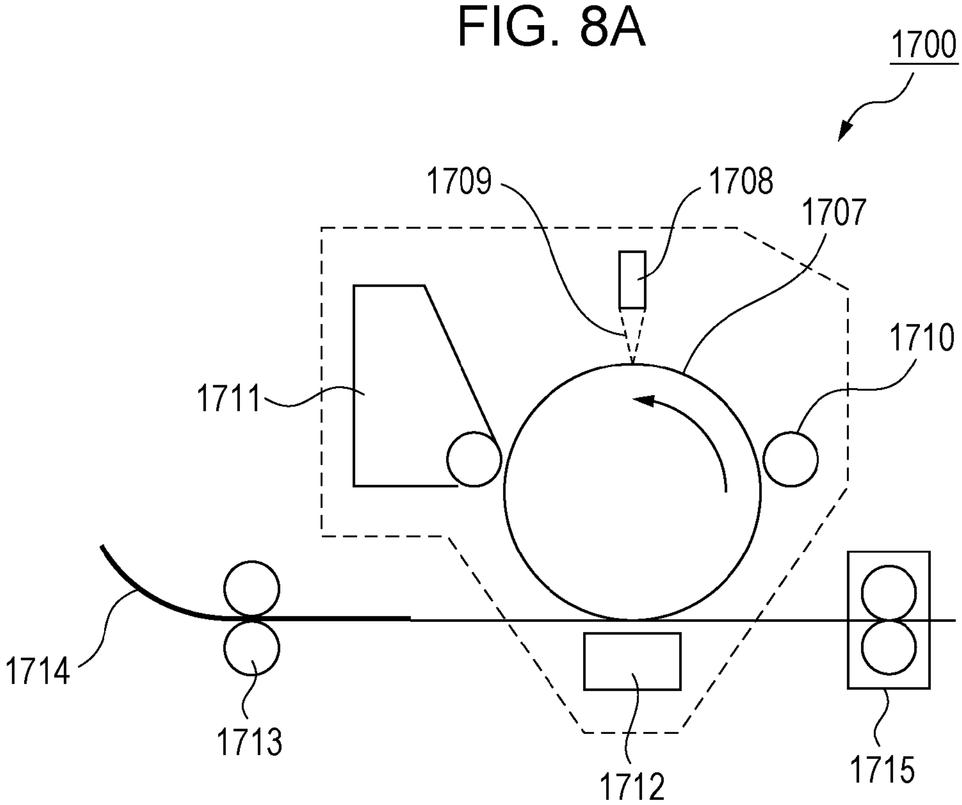


FIG. 8B

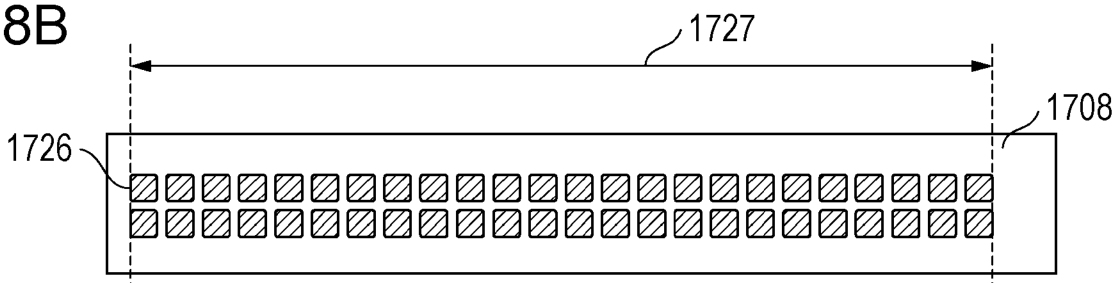


FIG. 8C

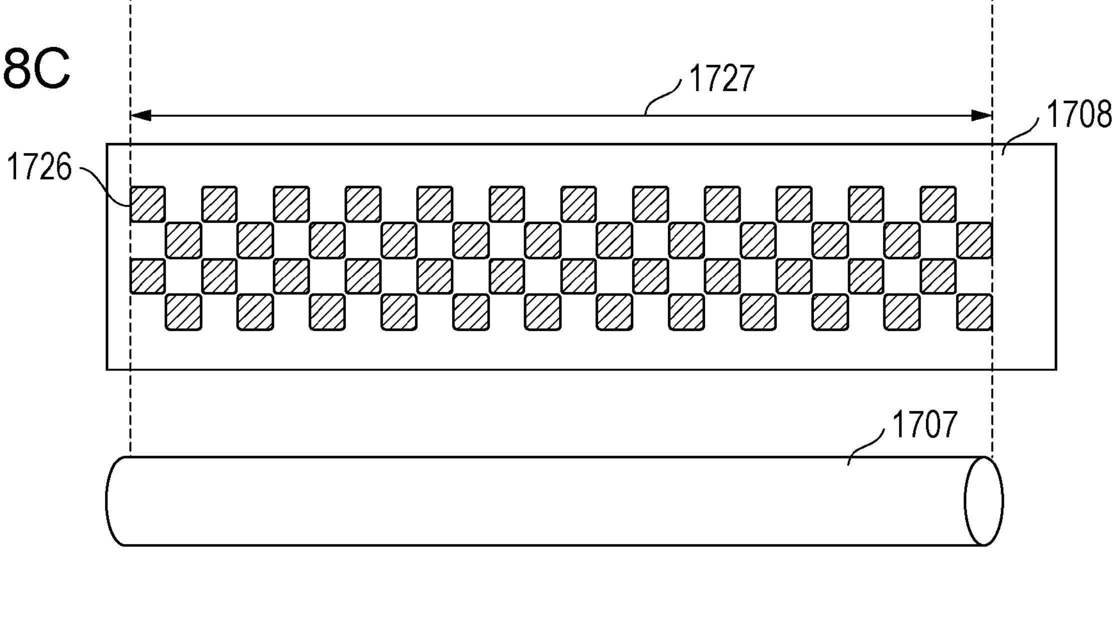

FIG. 9

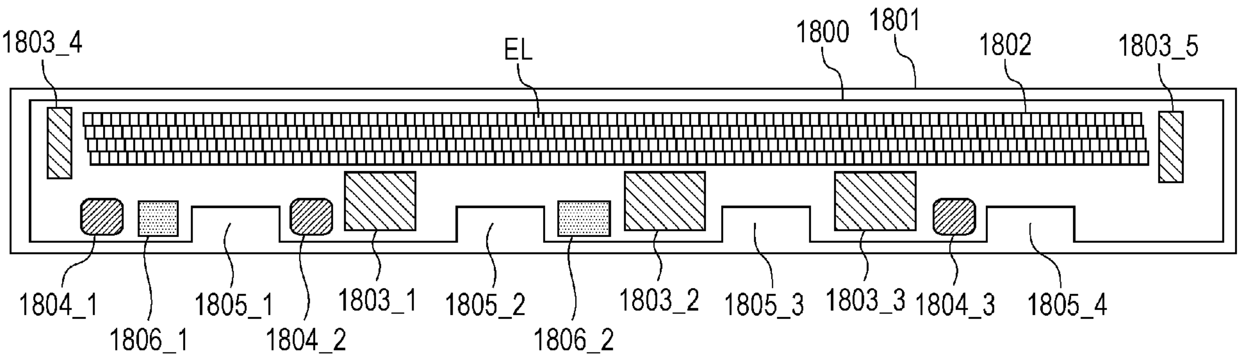
1803_4
EL
1800
1801
1802
1803_5
1804_1
1806_1
1805_1
1804_2
1803_1
1805_2
1806_2
1803_2
1805_3
1803_3
1804_3
1805_4

FIG. 10A

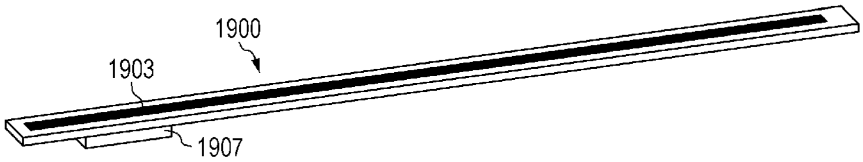


FIG. 10B

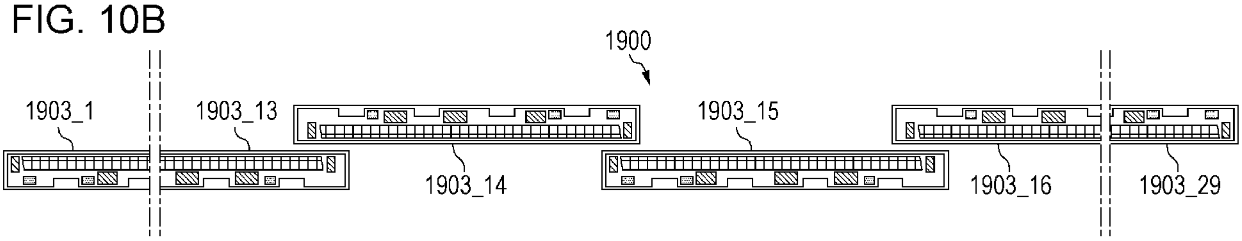


FIG. 10C

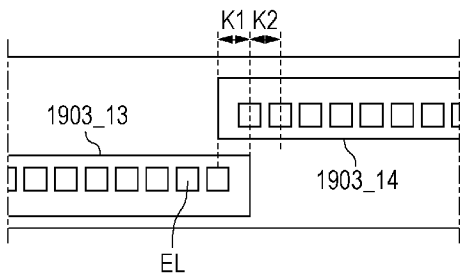

Europäisches Patentamt
European Patent Office
Office européen des brevets

# EUROPEAN SEARCH REPORT

Application Number
EP 24 15 8061

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHEON YE RIM ET AL: "Bis(1-phenyl-1H-benzo[d]imidazole)phenylphosphine oxide interlayer for effective hole blocking in efficient phosphorescent organic light emitting diodes based on widely used charge transporting layers", SYNTHETIC METALS, vol. 190, 1 April 2014 (2014-04-01), pages 39-43, XP093180725, CH ISSN: 0379-6779, DOI: 10.1016/j.synthmet.2014.01.018 | 1,2,7,9, 11-14 | INV. H10K50/11 H10K50/16 H10K50/15 ADD. H10K101/00 H10K101/30 H10K101/40 |
| A | * Device A; figures 2,3 * ----- | 3-6,8,10 | |
| X | CN 106 432 317 A (SHANGHAI EVERDISPLAY OPTRONICS CO LTD) 22 February 2017 (2017-02-22) | 1,2,7,9, 11-14 | |
| A | * examples 3-3 * ----- | 3-6,8,10 | |
| A,D | JP 2006 270091 A (FUJI PHOTO FILM CO LTD) 5 October 2006 (2006-10-05) * examples 6,7 * ----- | 1-14 | TECHNICAL FIELDS SEARCHED (IPC) H10K |
| A | US 2009/261324 A1 (NOGUCHI TAKAFUMI [JP] ET AL) 22 October 2009 (2009-10-22) * example 3 * ----- | 1-14 | |
| A | US 2015/188075 A1 (KIM HO SUNG [KR] ET AL) 2 July 2015 (2015-07-02) * paragraphs [0059], [0064] - [0066], [0074] * ----- | 1-14 | |
| A | US 2021/013439 A1 (SADO TAKAYASU [JP] ET AL) 14 January 2021 (2021-01-14) * Comparative Example 1 * ----- | 1-14 | |

The present search report has been drawn up for all claims

| Place of search | Date of completion of the search | Examiner |
|---|---|---|
| The Hague | 1 July 2024 | Welter, Steve |

3

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 15 8061

This annex lists the patent family members relating to the patent documents cited in the above-mentioned European search report. The members are as contained in the European Patent Office EDP file on
The European Patent Office is in no way liable for these particulars which are merely given for the purpose of information.

01-07-2024

| Patent document cited in search report | | Publication date | Patent family member(s) | | | Publication date |
|---|---|---|---|---|---|---|
| CN 106432317 | A | 22-02-2017 | NONE | | | |
| JP 2006270091 | A | 05-10-2006 | NONE | | | |
| US 2009261324 | A1 | 22-10-2009 | US | 2006194077 | A1 | 31-08-2006 |
| | | | US | 2009261324 | A1 | 22-10-2009 |
| | | | US | 2009261724 | A1 | 22-10-2009 |
| US 2015188075 | A1 | 02-07-2015 | CN | 104752480 | A | 01-07-2015 |
| | | | KR | 20150080334 | A | 09-07-2015 |
| | | | US | 2015188075 | A1 | 02-07-2015 |
| US 2021013439 | A1 | 14-01-2021 | CN | 111226325 | A | 02-06-2020 |
| | | | JP | 7171598 | B2 | 15-11-2022 |
| | | | JP | WO2019088231 | A1 | 12-11-2020 |
| | | | KR | 20200070398 | A | 17-06-2020 |
| | | | US | 2021013439 | A1 | 14-01-2021 |
| | | | WO | 2019088231 | A1 | 09-05-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006270091 A

### Non-patent literature cited in the description

- **M. J. FRISCH ; G. W. TRUCKS ; H. B. SCHLEGEL ; G. E. SCUSERIA ; M. A. ROBB ; J. R. CHEESEMAN ; G. SCALMANI ; V. BARONE ; B. MENNUCCI ; G. A. PETERSSON.** Gaussian 09, Revision C.01. Gaussian, Inc, 2010